(19) Europäisches Patentamt
European Patent Office
Office européen des brevets

(11) **EP 3 632 197 B1**

(12) **EUROPÄISCHE PATENTSCHRIFT**

(45) Veröffentlichungstag und Bekanntmachung des Hinweises auf die Patenterteilung:
**28.04.2021  Patentblatt 2021/17**

(21) Anmeldenummer: **18733187.1**

(22) Anmeldetag: **01.06.2018**

(51) Int Cl.:
**H05K 7/14** *(2006.01)*

(86) Internationale Anmeldenummer:
**PCT/EP2018/064536**

(87) Internationale Veröffentlichungsnummer:
**WO 2018/220214 (06.12.2018 Gazette 2018/49)**

(54) **LEISTUNGSPHASENMODUL EINES UMRICHTERS, UMRICHTER, UND FAHRZEUG**

POWER PHASE MODULE OF A CONVERTER, CONVERTER AND VEHICLE

MODULE DE PHASE DE PUISSANCE D'UN ONDULEUR, ONDULEUR ET VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.06.2017  DE 102017209454**

(43) Veröffentlichungstag der Anmeldung:
**08.04.2020  Patentblatt 2020/15**

(73) Patentinhaber: **Bombardier Transportation GmbH 10785 Berlin (DE)**

(72) Erfinder:
• **SCHMID, Roland**
  **8041 Z rich (CH)**
• **LAGGER, Stefan**
  **8307 Effretikon (CH)**
• **REICHELT, Reinhard**
  **79790 K ssaberg (DE)**
• **SCHWICHTENBERG, Klaus**
  **79793 Wut schingen (DE)**
• **LAUDAN, Adrian**
  **8107 Buchs ZH (CH)**

(74) Vertreter: **Patentanwälte Bressel und Partner mbB Potsdamer Platz 10 10785 Berlin (DE)**

(56) Entgegenhaltungen:
EP-A1- 2 562 922        DE-A1- 3 802 593
DE-A1-102015 118 591    DE-T2- 69 209 093

## Beschreibung

### Technisches Gebiet

Die Erfindung liegt auf dem Gebiet der Leistungselektronik, insbesondere der Leistungsumrichter, und betrifft den Aufbau eines Phasenmoduls für Leistungsumrichter und einen Umrichter. Weiterhin betrifft die Erfindung ein Fahrzeug mit einem Umrichter.

### Vorbekannter Stand der Technik

Umrichter dienen zur Umwandlung von Wechselspannung und Wechselstrom, wobei die charakteristischen Eigenschaften wie Spannungsamplitude und Frequenz dabei angepasst werden. Ein Umrichter kann ein Zwischenkreis aufweisen. Er dient als Zwischenspeicher und als elektrischer Puffer. Spannung und Strom werden bei Leistungsumrichtern gleichermaßen umgewandelt.

Verwendet werden Umrichter beispielsweise für Antriebe von drehzahlveränderlichen Elektromotoren. Diese kommen in Fahrzeugen, insbesondere in Schienenfahrzeugen, wie Straßenbahnen, Metros, elektrischen Lokomotiven oder Hochgeschwindigkeitszügen vor. Das Fahrzeug greift die Spannung über beispielsweise eine Oberleitung oder eine Stromschiene ab. Diese wird dann im Umrichter für den elektrischen Antrieb angepasst.

Elektromotoren werden ebenso als Dynamo zur Erzeugung von elektrischem Strom aus Bewegungsenergie, beispielsweise beim Bremsvorgang eines Elektrofahrzeuges, genutzt. Der Umrichter wirkt typischerweise in beide Richtungen.

Umrichter können Phasenmodule mit steuerbaren Halbleiterbauelementen, zum Beispiel IGBTs (insulated-gate bipolar transistor) aufweisen. Durch eine frequentierte Steuerung wird in dem Phasenmodul ein Phasenstrom generiert. Dieser kann dann beispielsweise einen Elektromotor antreiben.

DE 692 09 093 T2 beschreibt eine Antriebssteuereinrichtung mit einer Stromrichterbaugruppe, um den der Antriebssteuereinrichtung zugeführten Wechselstrom mit fester Frequenz in Gleichstromenergie umzuwandeln, einen Wechselrichter zum Wechselrichten des Gleichstroms vom Stromrichter in mehrphasigen Wechselstrom, der dem Motor zugeführt wird, und eine Steuerbaugruppe, die die Wechselrichterbaugruppe zur Veränderung der Frequenz des zugeführten Wechselstroms ansteuert. Der Wechselrichter weist eine Mehrzahl von Wechselrichtermodulen auf, die jeweils elektrisch mit dem Stromrichter verbunden sind. Fig. 2 der Druckschrift zeigt die Vorderseite eines Wechselrichtermoduls. Jedes Wechselrichtermodul enthält eine steife Rückwand mit einem Paar senkrechter, seitlich beabstandeter Stromschienen. Zwischen den Stromschienen befindet sich eine Ausgangswechselstromschiene, die ebenfalls an der Rückwand befestigt ist. Hinter der Ausgangsschiene ist an der Rückwand eine Steuerelektrodentreiberschaltung angebracht.

### Nachteile des Standes der Technik

Stromrichter in Schienenfahrzeugen bestehen aus großen Anordnungen von Stromrichtereinheiten, wobei jede Stromrichtereinheit an den Zwischenkreis angeschlossen ist. Lange Verbindungen zum Zwischenkreis erzeugen eine hohe Induktivität und einen damit verbundenen Leistungsverlust.

### Problemstellung

Die Aufgabe besteht darin, den Aufbau des Umrichters zu verbessern.

### Erfindungsgemäße Lösung

Diese Aufgabe wird durch ein Leistungsphasenmodul für einen modularen Umrichter nach Anspruch 1 gelöst. Weiterhin wird diese Aufgabe durch einen Umrichter nach Anspruch 11 und ein Fahrzeug, insbesondere ein Schienenfahrzeug, nach Anspruch 15 gelöst.

Es wird ein Leistungsphasenmodul für einen modularen Umrichter vorgeschlagen. Das Leistungsphasenmodul weist mindestens ein erstes DC-Anschlusspaar an einer Stirnseite des Leistungsphasenmoduls mit jeweiligen Verbindungselementen zum Anschließen an ein Stromschienenpaar; ein zum ersten DC-Anschlusspaar beabstandetes und zu diesem parallel geschaltetes erstes DC-Kondensator-Anschlusspaar an der Stirnseite mit jeweiligen Verbindungselementen zum Anschließen an ein dem Leistungsphasenmodul zugeordnetes Zwischenkreiskondensatormodul; einen ersten AC-Anschluss an einer anderen Seite des Leistungsphasenmoduls; eine Schaltvorrichtung verbunden mit dem ersten AC-Anschluss und dem ersten DC-Anschlusspaar zum Umrichten einer in einem Betriebszustand am ersten DC-Anschlusspaar anliegenden Gleichspannung in eine am ersten AC-Anschluss erzeugte Wechselspannung oder umgekehrt; und eine Kühlvorrichtung zum Abführen von Wärme aus dem Leistungsphasenmodul, insbesondere aus der Schaltvorrichtung, auf.

Das Leistungsphasenmodul kann in einem modular aufgebauten Umrichter zum Umrichten von Gleichstrom in Wechselstrom oder von Wechselstrom in Gleichstrom genutzt werden. In dem Umrichter können mehrere Leistungsphasenmodule parallel, unabhängig oder abhängig voneinander betrieben werden. Die Leistungsphasenmodule sind kompakt aufgebaut und können im modularen Umrichter platzsparend nebeneinander angeordnet sein. Vorteilhaft ist das Leistungsphasenmodul austauschbar.

Das Leistungsphasenmodul weist eine Stirnseite auf. Dazu kann es beispielsweise in etwa die Form eines Quaders mit großen und kleinen Seitenfläche haben. Die Stirnseite ist eine Seite mit einer kleinen Fläche.

An dieser Stirnseite weist das Leistungsphasenmodul mindestens ein erstes DC-Anschlusspaar auf. An das DC-Anschlusspaar kann ein Stromschienenpaar stirnseitig an das Leistungsphasenmodul angeschlossen werden. Das Leistungsphasenmodul wird bei angeschlossenen Stromschienen über das DC-Anschlusspaar mit einer Gleichspannung versorgt oder kann eine Gleichspannung speisen.

Das erste DC-Anschlusspaar ist für Gleichspannung ausgelegt und kann zwei Verbindungselemente aufweisen, die als zwei Anschlüsse mit korrespondierenden Kontaktelementen ausgebildet sind. Gemäß einer Ausführungsform sind während eines Betriebszustandes des Leistungsphasenmoduls die beiden Anschlüsse des ersten DC-Anschlusspaares auf unterschiedlichen Potentialen, sodass zwischen ihnen eine Gleichspannung anliegt. Die Anschlüsse des DC-Anschlusspaares sind so zueinander angeordnet und elektrisch isoliert, dass in einem normalen Betriebszustand kein Strom zwischen ihnen fließen kann. Als Isolation zwischen den Anschlüssen kann sich beispielsweise Luft befinden. Ebenso können die Anschlüsse durch eine Beschichtung elektrisch isoliert sein.

Das Leistungsphasenmodul weist an der Stirnseite weiterhin ein zum ersten DC-Anschlusspaar beabstandetes und zu diesem parallel geschaltetes erstes DC-Kondensator-Anschlusspaar auf. An das erste DC-Kondensator-Anschlusspaar kann ein dem Leistungsphasenmodul zugeordnetes Zwischenkreiskondensatormodul angeschlossen werden. Dazu können die Verbindungselemente des ersten DC-Kondensator-Anschlusspaares mit Anschlüssen des Zwischenkreiskondensatormoduls verbunden werden. Die Verbindung zwischen dem DC-Kondensator-Anschlusspaar und dem Zwischenkreiskondensatormodul ist insbesondere lösbar, beispielsweise sind die Verbindungselemente als Bohrlöcher ausgebildet und die Anschlüsse des Zwischenkreiskondensatormoduls weisen als korrespondierende Kontaktelemente Schrauben oder Strombolzen auf.

Gemäß einer Ausführungsform weist das erste DC-Kondensator-Anschlusspaar zwei Anschlüsse auf, die während eines Betriebszustandes des Leistungsphasenmoduls auf unterschiedlichen Potentialen liegen und zwischen denen eine Gleichspannung anliegt. Die beiden Anschüsse sind elektrisch voneinander isoliert und beabstandet. Sie können nah nebeneinander liegen, insbesondere können sie so angeordnet sein, dass zwischen den zwei Anschlüssen des DC-Kondensator-Anschlusspaares kein weiterer stromdurchflossener Leiter angeordnet ist.

Gemäß einer Ausführungsform weist das erste DC-Anschlusspaar zwei Anschlüsse auf, die während eines Betriebszustandes des Leistungsphasenmoduls auf unterschiedlichen Potentialen liegen und zwischen denen eine Gleichspannung anliegt. Die Anschlüsse können räumlich nah aneinander an der Stirnseite liegen.

In Zwischenkreisen von Umrichtern werden üblicherweise elektrische Kondensatoren verbaut. Bei hohen Strömen bzw. hoher Leistungsdichte des Umrichters kann eine hohe Strombelastbarkeit bei gleichzeitiger geringer Eigeninduktivität des Zwischenkreiskondensators vorteilhaft für die Effizienz sein. Ein geringer effektiver Serienwiderstand (ESR) und eine geringe effektive Serieninduktivität (ESL) sind Anforderungen für einen guten Wirkungsgrad. Ein niederinduktiver Anschluss des Zwischenkreiskondensators an die Schaltvorrichtung kann ebenso zu einer Erhöhung der Effizienz führen. Ein niederinduktiver Anschluss kann ebenso zu einer Entlastung der Halbleiterbeanspruchung durch Schaltspannungen und Schaltströmen führen.

Die Induktivität des Anschlusses der Schaltvorrichtungen an den Kondensator wird unter anderem durch die Länge der elektrischen Leitung bzw. die Größe der Leiterschleife bestimmt. Je größer die Leiterschleife, desto größer die Induktivität. Der Zwischenkreiskondensator sollte daher möglichst nah an der Schaltvorrichtung platziert werden. Das erste DC-Kondensator-Anschlusspaar an der Stirnseite ist gemäß einer Ausführungsform derart ausgeführt, dass ein Zwischenkreiskondensatormodul im Wesentlichen unmittelbar an das erste DC-Kondensator-Anschlusspaar angeschlossen werden kann. Das heißt, dass das Zwischenkreiskondensatormodul räumlich möglichst nah an dem Leistungsphasenmodul angeordnet werden kann.

Hierzu ist das Leistungsphasenmodul so angeordnet, dass die Stirnseite des Leistungsphasenmoduls dem Zwischenkreiskondensatormodul direkt gegenübersteht. Insbesondere weist das Zwischenkreiskondensatormodul zumindest eine Fläche auf, an der elektrische Kontaktelemente zum Anschluss des DC-Kondensator-Anschlusspaars an das Zwischenkreiskondensatormodul angeordnet sind. Vorzugsweise sind die elektrischen Kontaktelemente ausschließlich an einer Fläche des Zwischen kreiskondensatormoduls angeordnet. Das Leistungsphasenmodul ist derart angeordnet, dass die erste Stirnseine des Leistungsphasenmoduls der einen Fläche des Zwischenkreiskondensatormoduls gegenübersteht. Das Leistungsphasenmodul ist mit seiner Stirnseite also auf einem ihm zugeordneten Zwischenkreiskondensatormodul angeordnet. Hierdurch wird vorteilhafterweise eine sehr kurze und induktivitätsarme Anschlusssituation zwischen dem Zwischenkreiskondensator und der Schaltvorrichtung geschaffen. Das beinhaltet auch Verbindungselemente zwischen dem DC-Kondensator-Anschlusspaar und dem Zwischenkreiskondensatormodul, die insbesondere lösbar sind. Die Verbindungselemente können sowohl mechanische Befestigungsmittel als auch elektrisch leitende Verbindungen umfassen. Beispielsweise sind die Verbindungselemente Schraubverbindungen.

Das Zwischenkreiskondensatormodul weist mindestens einen Kondensator auf. Der Kondensator wirkt als Zwischenkreiskondensator des Leistungsphasenmoduls. Während eines Schaltvorganges der Schaltvorrichtung ändert sich der Strom in dem Kondensator.

Er ist daher Teil des Kommutierungskreises. Der Zwischenkreiskondensator wird auch Kommutierungskondensator genannt.

Das Leistungsphasenmodul weist an einer anderen Seite als der Stirnseite einen ersten AC-Anschluss auf. Über den ersten AC-Anschluss wird das Leistungsphasenmodul mit einer Wechselspannung versorgt oder kann eine Wechselspannung speisen. Diese andere Seite kann gegenüber der Stirnseite liegen und selbst andere Stirnseite sein.

Das Leistungsphasenmodul weist weiterhin eine Schaltvorrichtung auf. Die Schaltvorrichtung ist mit dem ersten AC-Anschluss und dem ersten DC-Anschlusspaar verbunden. Die Schaltvorrichtung ist geeignet zum Umrichten einer in einem Betriebszustand am ersten DC-Anschlusspaar anliegenden Gleichspannung in eine am ersten AC-Anschluss erzeugte Wechselspannung oder umgekehrt. Die Schaltvorrichtung ist also elektrisch zwischen das erste DC-Anschlusspaar und den ersten AC-Anschluss geschaltet.

Gemäß einer Ausführungsform ist die Schaltvorrichtung nicht nur elektrisch sondern ebenso räumlich zwischen dem erste DC-Anschlusspaar und dem ersten AC-Anschluss angeordnet. Dabei kann es Überlappbereiche geben. Ein Ziel der Erfindung ist unter anderem die Minimierung der Induktivität. Das kann durch Minimierung der Größe und Länge von Leiterschleifen geschehen. Eine kompakte räumliche Anordnung ist daher sinnvoll.

Gemäß einer Ausführungsform liegt in einem Betriebszustand des Leistungsphasenmoduls eine Gleichspannung am ersten DC-Anschlusspaar an. Über die Verbindung des ersten DC-Anschlusspaares mit der Schaltvorrichtung kann ein Strom durch die Schaltvorrichtung über die Verbindung mit dem ersten AC-Anschluss zu diesem fließen. Abhängig von der Schaltvorrichtung kann diese so betrieben werden, dass am ersten AC-Anschluss eine Wechselspannung erzeugt wird.

Gemäß einer Ausführungsform weist die Schaltvorrichtung mindestens eines der folgenden elektronischen Bauteile auf: Diode, Leistungs-MOSFET, und IGBT. Insbesondere können dabei auch Schaltungen aus mehreren Dioden-, IGBT-Halbbrücken oder -Vollbrücken oder Kombinationen daraus Teil der Schaltvorrichtung sein.

Gemäß einer Ausführungsform weist die eine oder weisen mehrere Schaltvorrichtungen des Leistungsphasenmoduls jeweils mindestens eine Dioden-Halbbrücke oder eine IGBT-Halbbrücke auf.

Bei der Umwandlung von Gleichspannung in Wechselspannung erzeugt die Schaltvorrichtung gemäß einer Ausführungsform eine Frequenz oder gibt eine Frequenz vor, mit der der Gleichstrom in einen Wechselstrom mit eben dieser Frequenz umgewandelt wird. Die Schaltvorrichtung kann dazu eine Steuerung, insbesondere eine Gatesteuerung, aufweisen oder mit einer Steuerung verbunden sein.

Gemäß einer Ausführungsform weist das Leistungsphasenmodul mindestens eine Steuerung zum Steuern der Schaltvorrichtung auf. Die Steuerung ist vorteilhaft an der anderen Stirnseite, also der Stirnseite der AC-Anschlüsse, angeordnet.

Gemäß einer Ausführungsform weist das Leistungsphasenmodul, insbesondere die Schaltvorrichtung, ein oder mehrere Anschlüsse einer Steuerung zum Steuern der einen oder mehreren Schaltvorrichtungen auf. Die Steuerung kann über elektrische Signale, zum Beispiel über Kupferleitungen, oder über optische Signale, zum Beispiel über Lichtwellenleiter, erfolgen.

Gemäß einer Ausführungsform weist das Leistungsphasenmodul eine weitere oder mehrere zusätzliche Schaltvorrichtungen auf. Zwei oder mehrere Schaltvorrichtungen können an denselben AC-Anschluss angeschlossen werden, wenn ihre Frequenzen und Phasen kompatibel sind. Jede Schaltvorrichtung kann jedoch auch an einen separaten AC-Anschluss angeschlossen werden und das Leistungsphasenmodul weist dann weitere AC-Anschlüsse auf.

Mehrere Schaltvorrichtungen können gemäß einer Ausführungsform parallel zueinander zwischen dem ersten DC-Anschlusspaar und dem oder den AC-Anschlüssen geschaltet sein. Bei mehreren DC-Anschlusspaaren können die Schaltvorrichtungen parallel zueinander zwischen den DC-Anschlusspaaren und dem oder den AC-Anschlüssen geschaltet sein.

Gemäß einer Ausführungsform weist das Leistungsphasenmodul weiterhin einen Power Supply Anschluss zum Speisen von Gate-Treibern der Schaltvorrichtung auf. Die Gate-Treiber können mit den unterschiedlichen Ausführungsformen der Schaltvorrichtungen, also den Halbleiterkomponenten und deren Schaltungen variieren. Beispielsweise kann an einen Power Supply Anschluss eine Spannung von 24V oder 110V während eines Betriebszustandes angeschlossen sein. Diese entsprechen typischen Spannungen in einem Schienenfahrzeug durch z.B. die Fahrzeugbatterie.

Gemäß einer Ausführungsform weist eine Schaltvorrichtung ein oder mehrere Schaltmodule, insbesondere ein Dual-Schaltmodul oder zwei Einzel-Schaltmodule, auf. Bei einem Dual-Schaltmodul ist dieses sowohl mit dem ersten als auch mit dem zweiten Anschluss des DC-Anschlusspaares verbunden. Bei einem Einzel-Schaltmodul ist jeweils nur ein Anschluss des DC-Anschlusspaares mit dem Einzel-Schaltmodul verbunden.

Ein Dual-Schaltmodul kann elektrisch einem Zweiweg-Gleichrichter entsprechen. Es nutzt beide Potentiale des DC-Anschlusspaares aus und wandelt es durch eine entsprechende Steuerung in eine Wechselspannung um. Ein Einzel-Schaltmodul kann elektrisch als Einweg-Gleichrichter gesehen werden. Es nutzt nur ein Potential des DC-Anschlusspaares aus. Zwei Einzel-Schaltmodule bilden elektrisch einen Zweiweg-Gleichrichter.

Gemäß einer Ausführungsform liegt die Spannungsklasse der Schaltvorrichtungen, insbesondere des gesamten Leistungsphasenmoduls, bei etwa 1200V bis etwa 6500V.

Gemäß einer Ausführungsform fließt ein elektrischer Strom von einem DC-Anschlusspaar zu einem AC-Anschluss über eine Schaltvorrichtung in einem Betriebszustand von mindestens 300A (Dualschalter) oder mindestens 800A (Einzelschalter).

Gemäß einer Ausführungsform werden die eine oder mehrere Schaltvorrichtungen so gesteuert, dass sie aus der anliegenden Gleichspannung eine Wechselspannung an ihrem AC-Anschluss erzeugen. Die Steuerung der Schaltvorrichtung kann insbesondere eine Gatesteuerung sein, wenn die Schaltvorrichtungen steuerbare Halbleiterkomponenten mit Gates, insbesondere IGBTs, aufweisen.

Gemäß einer Ausführungsform weist das Leistungsphasenmodul eine Gatesteuerung auf. Die Gatesteuerung ist mit der Schaltvorrichtung verbunden und eingerichtet, die Schaltvorrichtung so zu steuern, dass eine an der Schaltvorrichtung anliegende Gleichspannung in eine Wechselspannung gewandelt wird, oder umgekehrt.

Gemäß einer Ausführungsform weist die Schaltvorrichtung zwei Einzel-Schaltmodule mit jeweils einer Diode auf, wobei die Dioden antiparallel zueinander sind. In dieser Ausführungsform ist die entstehende Halbbrücke eine passive Schaltung. Zwei dieser halbbrücken ergeben einen ungesteuerten Gleichrichter.

Gemäß einer weiteren Ausführungsform weist die Schaltvorrichtung ein Dual-Schaltmodul auf. Das Dual-Schaltmodul weist eine Halbbrücke mit Schaltern und antiparalleler Diode auf; oder das Dual-Schaltmodul weist einen Halbbrückengleichrichter mit Dioden auf.

Gemäß einer weiteren Ausführungsform weist die Schaltvorrichtung ein Dual-Schaltmodul mit einer Chopperhalbbrücke mit einem Halbleiterschalter und antiparalleler Diode sowie einer Diode auf. Halbleiterschalter, insbesondere IGBT, und die dazugehörige antiparallele Diode können auch auf einem Chip integriert sein. Dies trifft auch auf einen Power MOSFET zu, dessen antiparallele Diode monolithisch integriert ist.

Gemäß einer Ausführungsform weist das Leistungsphasenmodul 1 bis 6 Schaltmodule (Einzel- oder Dual-Schaltmodule) auf.

Das Leistungsphasenmodul kann zusätzlich zum ersten AC-Anschluss weitere AC-Anschlüsse aufweisen. Gemäß einer Ausführungsform weist das Leistungsphasenmodul 1 bis 6 AC-Anschlüsse auf. Dabei können unterschiedliche Ausführungsformen von Schaltvorrichtungen in einem Leistungsphasenmodul verbaut und den AC-Anschlüssen zugeordnet sein. Das Leistungsphasenmodul kann 1 bis 6 Schaltvorrichtungen aufweisen.

Ein AC-Anschluss des Leistungsphasenmoduls kann als Lastanschluss für beispielsweise den Phasenanschluss eines Elektromotors genutzt werden. Der Strom fließt dabei von einem Anschluss des DC-Anschlusspaars über die Schaltvorrichtung über den AC-Anschluss zum Elektromotor. Umgekehrt kann der AC-Anschluss als Einspeisung von Wechselstrom durch einen Generator beispielsweise bei einem Bremsvorgang eines elektrischen Fahrzeuges durch eine Nutzbremse genutzt werden. Der Strom wird im Generator erzeugt und fließt über den AC-Anschluss über die Schaltvorrichtung in das DC-Anschlusspaar. Ein angeschlossener Kondensator in einem Zwischenkreiskondensatormodul dient als Energiezwischenspeicher und als elektrischer Puffer während des Umrichtens.

Das Leistungsphasenmodul weist weiterhin eine Kühlvorrichtung zum Abführen von Wärme aus dem Leistungsphasenmodul, insbesondere aus der Schaltvorrichtung, auf. In einem Betriebszustand entsteht durch den Ohm'schen Widerstand der stromleitenden Komponenten des Leistungsphasenmoduls Wärme. Insbesondere in der oder den Schaltvorrichtungen wird elektrische Energie in parasitäre Wärme umgewandelt. Durch steigende Temperaturen sinkt in der Regel die Effizienz der Komponenten. Die Kühlvorrichtung schützt das Leistungsphasenmodul vor einer Zerstörung durch Hitze und kühlt es auf eine effiziente Arbeitstemperatur herunter.

Gemäß einer Ausführungsform ist die Kühlvorrichtung als Kühlplatte ausgebildet. Auf der Kühlplatte kann die Schaltvorrichtung derart angeordnet sein, dass die in den Schaltvorrichtungen entstehende Wärme durch die Kühlvorrichtung abgeführt werden kann. Die Kühlplatte kann als mechanischer Träger der Schaltvorrichtungen ausgebildet sein.

Gemäß einer Ausführungsform weist die Kühlvorrichtung ein Kühlmittel auf. Das Kühlmittel kann ein Gas oder eine Flüssigkeit sein, insbesondere im Wesentlichen Wasser oder Luft. Anpassungen des Kühlmittels kann der Fachmann entsprechend gängiger Kühlvorrichtungen für vergleichbare elektronische Baugruppen vornehmen.

Gemäß einer Ausführungsform weist die Kühlvorrichtung Hydraulikanschlüsse zum Führen von Kühlmittel in die und aus der Kühlvorrichtung auf. Die Hydraulikanschlüsse können an ein Kühlmittelsystem angeschlossen werden. Beispielsweise können die Hydraulikanschlüsse als Schnellkupplungen aufgeführt sein und durch ein Aufstecken an entsprechende Anschlüsse eines Kühlmittelsystems mit diesem verbunden werden.

Gemäß einer Ausführungsform hat das Leistungsphasenmodul in etwa die Form eines Quaders mit großflächigen und kleinflächigen Seiten. Die Stirnseite ist eine Seite mit kleiner Fläche. Die Schaltvorrichtungen, insbesondere die Einzel- oder Dual- Schaltmodule der Schaltvorrichtungen, sind nebeneinander in einer Ebene senkrecht zur Stirnseite angeordnet. Die Kühlvorrichtung ist derart mit der Schaltvorrichtung beziehungsweise den Schaltmodulen verbunden, dass entstehende Wärme über das in der Kühlvorrichtung strömende Kühlmittel aus der Schaltvorrichtung beziehungsweise den Schaltmodulen und abgeführt wird. Beispielsweise kann die Kühlvorrichtung die Schaltvorrichtungen bzw. die Schaltmodule teilweise umschließen oder die Kühlvorrichtung kann als plattenförmiges Element ausgebildet sein, auf dem die Schaltvorrichtungen bzw. die Schaltmodule angeordnet und wärmeleitend verbunden sind.

Gemäß einer Ausführungsform ist die Schaltvorrichtung des Leistungsphasenmoduls austauschbar. Das heißt, die Schaltvorrichtung ist derart lösbar im Leistungsphasenmodul mit den anderen Komponenten verbunden, dass sie ausgebaut werden kann, ohne andere Bestandteile des Leistungsphasenmoduls zu zerstören. Die Schaltvorrichtung ist dazu lösbar befestigt, beispielsweise durch lösbare Befestigungsmittel wie Schrauben.

Gemäß Patentanspruch 1 sind das erste DC-Anschlusspaar und das erste DC-Kondensator-Anschlusspaar aus von Querbrücken abgewinkelten Metallblechbereichen gebildet und diese Metallblechbereiche im Wesentlichen in einer Ebene angeordnet. Die jeweiligen Verbindungselemente des ersten DC-Anschlusspaars und des ersten DC-Kondensator-Anschlusspaars sind an oder in den abgewinkelten Metallblechbereichen ausgebildet.

Gemäß einer Ausführungsform sind der erste Anschluss des ersten DC-Anschlusspaares und des ersten DC-Kondensator-Anschlusspaares aus einem, insbesondere einstückigen, Metallblech geformt. Die Anschlüsse können Verbindungselemente, zum Beispiel, Bohrlöcher für Befestigungsmittel, aufweisen. Das kann analog für die zweiten Anschlüsse des ersten DC-Anschlusspaares und des ersten DC-Kondensator-Anschlusspaares gelten, wobei die Anschlüsse jeweils unabhängig voneinander und unterschiedlich geformt sein können.

Gemäß einer Ausführungsform weisen die beiden Anschlüsse des DC-Kondensator-Anschlusspaares einen anderen Abstand zueinander auf als die beiden Anschlüsse des ersten DC-Anschlusspaares. Die Anschlüsse des DC-Kondensator-Anschlusspaares sind für den Anschluss an ein Zwischenkreiskondensatormodul bzw. einen Zwischenkreiskondensator vorgesehen. Die beiden Anschlüsse des ersten DC-Anschlusspaares sind für den Anschluss an Stromschienen vorgesehen. Der Abstand zweier Stromschienen kann sich zum Abstand zweier Zwischenkreiskondensatoranschlüsse unterscheiden.

Gemäß einer Ausführungsform weisen die Verbindungselemente des ersten und/oder des zweiten DC-Kondensator-Anschlusspaares einen anderen Abstand zueinander auf als die Verbindungselemente des ersten und/oder des zweiten DC-Anschlusspaares.

Gemäß dieser Ausführungsform können die Anschlüsse des ersten DC-Anschlusspaares an Stromschienen und die Anschlüsse des ersten DC-Kondensator-Anschlusspaares an ein Zwischenkreiskondensatormodul angeschlossen werden, wobei die Stromschienen und das Zwischenkreiskondensatormodul ebenso im Wesentlichen in einer Ebene angeordnet sind. Durch den räumlich nahen Anschluss des Zwischenkreiskondensatormoduls an das DC-Kondensator-Anschlusspaar, wird die entstehende geometrische Größe der Leiterschleife verringert und dadurch die Induktivität des Zwischenkreises ebenso verringert.

Gemäß dieser Ausführungsform ist jedem Leistungsphasenmodul jeweils genau ein Zwischenkreiskondensatormodul zugeordnet und das Zwischenkreiskondensatormodul weist mindestens einen Kondensator auf. Typische Kapazitäten des Zwischenkreiskondensatormoduls liegen im Bereich von einigen hundert Mikrofarad bis mehr als 1000 Mikrofarad und können abhängig von der Spannung im Zwischenkreis gewählt werden. Beispielsweise kann die Kapazität bei 400µF für 3,6kV, bei 700µF für 2.8kV, bei 1600µlF für 1.8kV oder bei 9000µF bei 750V liegen. Diese diskreten Werte sind lediglich durch die typischen Zielwerte bei der Herstellung der Kondensatoren gegeben und nicht darauf beschränkt. Die Gesamtkapazität ist durch einen oder mehrere parallel geschaltete Kondensatoren im Zwischenkreiskondensatormodul gegeben.

Gemäß einer Ausführungsform sind die Anschlüsse des anzuschließenden Zwischenkreiskondensatormoduls als Messerkontakte ausgebildet. Dabei können in einem Betriebszustand mehrere mechanische Messerkontakte, die zu zwei Kontaktgruppen zusammenfassbar sind, auf jeweils einem ersten oder einem zweiten Potential sein. Alternativ kann das Zwischenkreiskondensatormodul auch nur ein einzelnes Messerkontaktpaar aufweisen. Die Anzahl der DC-Kondensator-Anschlusspaare ist an die Kontakte des Zwischenkreiskondensatormoduls angepasst. Jede Kontaktgruppe kann beispielsweise drei Messerkontakte mit entsprechenden Verbindungselementen aufweisen. Zusätzlich zum ersten DC-Kondensator-Anschlusspaar weist das Leistungsphasenmodul dann zwei weitere DC-Kondensator-Anschlusspaare auf, sodass alle sechs Anschlüsse der DC-Kondensator-Anschlusspaare mit den jeweils drei Messerkontakten verbindbar sind.

Gemäß einer Ausführungsform weist das Leistungsphasenmodul weiterhin ein zweites DC-Kondensator-Anschlusspaar und gegebenenfalls ein drittes DC-Kondensator-Anschlusspaar auf, wobei das erste DC-Kondensator-Anschlusspaar und das zweite DC-Kondensator-Anschlusspaar und gegebenenfalls das dritte DC-Kondensator-Anschlusspaar lösbar mit einem Zwischenkreiskondensatormodul mit vier Anschlüssen beziehungsweise mit sechs Anschlüssen verbindbar sind. Dazu können die zusätzlichen DC-Kondensator-Anschlusspaare ebenfalls Verbindungselemente aufweisen. Alternativ kann das Leistungsphasenmodul auch zwei DC-Kondensator-Anschlusspaare aufweisen, wobei zwei Anschlüsse jedes DC-Kondensator-Anschlusspaares zu einem gemeinsamen Anschluss zusammengefasst und ausgebildet sind. Vorteilhaft ist der gemeinsame Anschluss derart ausgebildet, dass er elektrisch analoge Eigenschaften, insbesondere eine im Wesentlichen gleiche Impedanz, im Vergleich zu der Summe der beiden anderen Anschlüssen aufweist.

Gemäß einer Ausführungsform weist das Leistungsphasenmodul ein zweites DC-Kondensator-Anschlusspaar auf, das an der Stirnseite des Leistungsphasenmoduls zum ersten DC-Anschlusspaar und zum ersten DC-Kondensator-Anschlusspaar jeweils beabstandet angeordnet und parallel geschaltet ist.

Gemäß einer Ausführungsform weisen das erste oder das erste und das zweite DC-Kondensator-Anschlusspaar zum lösbaren Verbinden mit korrespondierenden Kontaktelementen eines an der Stirnseite platzierbaren Zwischenkreiskondensatormoduls ausgebildet sind.

Gemäß einer Ausführungsform weist ein Zwischenkreiskondensatormodul mindestens einen Kondensator und zwei oder mehr Anschlüsse auf. Der Kondensator ist zwischen die beiden Anschlüssen geschaltet. Das Zwischenkreiskondensatormodul kann auch mehrere parallel geschaltete Kondensatoren aufweisen oder die Kondensatoren werden durch den Anschluss mit dem Leistungsphasenmodul parallel geschaltet.

Gemäß einer Ausführungsform weist das Leistungsphasenmodul weiterhin ein zweites DC-Anschlusspaar auf, das an der Stirnseite des Leistungsphasenmoduls zum ersten DC-Anschlusspaar und zum ersten DC-Kondensator-Anschlusspaar jeweils beabstandet angeordnet und parallel geschaltet ist. Das zweite DC-Anschlusspaar kann ebenso zwei Verbindungselemente an zwei Anschlüssen aufweisen, die in einem Betriebszustand auf unterschiedlichen Potentialen liegen.

Gemäß dieser Ausführungsform können die Anschlüsse der beiden DC-Anschlusspaare jeweils räumlich nah aneinander ausgebildet sein zum Anschließen an jeweils zwei streckenweise parallel verlaufende Stromschienenpaare. Durch das räumlich nahe Führen der beiden Stromrichtungen werden die Größen von Leiterschleifen minimiert und die Induktivität verringert. Das hat einen positiven Effekt auf die Effizienz.

Gemäß einer Ausführungsform sind das erste DC-Kondensator-Anschlusspaar oder das erste und das zweite DC-Kondensator-Anschlusspaar zwischen dem ersten DC-Anschlusspaar und dem zweiten DC-Anschlusspaar in einer Reihe angeordnet. Dadurch kann ein Zwischenkreiskondensatormodul zwischen zwei Stromschienenpaaren angeordnet sein. Das verringert den Abstand des Zwischenkreiskondensators zur Schaltvorrichtung und verringert dadurch die Induktivität. Die Anschlüsse der DC-Anschlusspaare sind dann räumlich nah aneinander, sodass immer zwei Leiter mit entgegengesetzten Stromrichtungen räumlich nah angeordnet sind. Die Größen der Leiterschleifen werden dadurch minimiert.

Ein angeschlossenes Zwischenkreiskondensatormodul ist gemäß dieser Ausführungsform zwischen den beiden DC-Anschlusspaaren angeordnet und an das DC-Kondensator-Anschlusspaar angeschlossen. An die beiden DC-Anschlusspaare sind jeweils zwei Stromschienenpaare angeschlossen. Diese Anordnung enthält eine Symmetrie. In einem Betriebszustand mit angeschlossenen Stromschienen und Zwischenkreiskondensatormodul sind stromführende Leiter eines Potentials und stromführende Leiter des anderen Potentials durch die symmetrische Anordnung räumlich nah aneinander, sodass die Größe der dadurch gebildeten Leiterschleifen minimiert wird und damit die Induktivität minimiert wird.

Das System kann eine hohe Impedanzsymmetrie aufweisen, wodurch ein symmetrischer Stromfluss in und aus dem Zwischenkreiskondensatormodul ermöglicht wird. Folgende Symmetrien sind unabhängig voneinander möglich und vorteilhaft.

Gemäß einer Ausführungsform sind die Impedanzen der Anschlüsse des ersten DC-Anschlusspaares im Wesentlichen identisch.

Gemäß einer Ausführungsform sind die Impedanzen der Anschlüsse des ersten DC-Kondensator-Anschlusspaares im Wesentlichen identisch.

Gemäß einer Ausführungsform sind die Impedanzen der Anschlüsse des zweiten DC-Kondensator-Anschlusspaares im Wesentlichen identisch.

Gemäß einer Ausführungsform sind die Impedanzen der Anschlüsse des zweiten DC-Anschlusspaares im Wesentlichen identisch.

Gemäß einer Ausführungsform sind die Impedanzen der Anschlüsse des ersten DC-Kondensator-Anschlusspaares und des zweiten DC-Kondensator-Anschlusspaares im Wesentlichen identisch.

Gemäß einer Ausführungsform sind die Impedanzen der Anschlüsse des ersten DC-Anschlusspaares und des zweiten DC-Anschlusspaares im Wesentlichen identisch.

Gemäß einer Ausführungsform weisen das erste DC-Anschlusspaar, das erste DC-Kondensator-Anschlusspaar und die Schaltvorrichtung jeweils einen ersten Anschluss auf und das Leistungsphasenmodul weist weiterhin eine erste Querbrücke auf, die die ersten Anschlüsse des ersten DC-Anschlusspaares, des ersten DC-Kondensator-Anschlusspaares und der Schaltvorrichtung elektrisch verbindet.

Gemäß einer Ausführungsform weisen das erste DC-Anschlusspaar, das erste DC-Kondensator-Anschlusspaar und die Schaltvorrichtung jeweils einen zweiten Anschluss auf und das Leistungsphasenmodul weist weiterhin eine zweite Querbrücke auf, die die zweiten Anschlüsse des ersten DC-Anschlusspaares, des ersten DC-Kondensator-Anschlusspaares und der Schaltvorrichtung elektrisch verbindet.

Gemäß einer Weiterentwicklung der Ausführungsform verbindet die erste Querbrücke zusätzlich die ersten Anschlüsse weiterer DC-Anschlusspaare und/oder weiterer DC-Kondensator-Anschlusspaare und/oder weiterer Schaltvorrichtungen. Die zweite Querbrücke kann ebenso zusätzlich die zweiten Anschlüsse weiterer DC-Anschlusspaare und/oder weiterer DC-Kondensator-Anschlusspaare und/oder weiterer Schaltvorrichtungen verbinden.

Es können mehrere parallel geschaltete Schaltvorrichtungen über jeweils einen ersten Anschluss mit der ersten Querbrücke und gegebenenfalls jeweils einen zweiten Anschluss mit der zweiten Querbrücke verbunden sein.

Über die beiden Querbrücken fließt in einem Betriebszustand des Leistungsphasenmoduls gemäß dieser Ausführungsform ein Gleichstrom von den Anschlüssen des oder der DC-Anschlusspaare zu der oder den Schaltvorrichtungen und über das oder die DC-Kondensator-Anschlusspaare zum Zwischenkreiskondensatormodul.

Die erste Querbrücke und die zweite Querbrücke können unmittelbar nebeneinander und abschnittsweise parallel zueinander verlaufen ohne in direktem elektrischem Kontakt zu stehen. Dadurch wird eine im Wesentlichen symmetrische Impedanz für mehrere parallel geschaltete Schaltvorrichtungen erzeugt. Das ermöglicht einen symmetrischen Stromfluss durch die Querbrücken und die Schaltvorrichtungen.

Die Querbrücken sind für eine hohe Strombelastung ausgelegt. Sie weisen einen möglichst kleinen Ohm'schen Widerstand auf. Die Querbrücken können Metalle mit hoher Leitfähigkeit, insbesondere Kupfer oder Aluminium aufweisen. Die Querbrücken können weiterhin eine Beschichtung beispielsweise als Korrosionsschutz und/oder als Schutz vor elektrischen Überschlägen aufweisen.

Gemäß einer Ausführungsform sind die Querbrücken einstückig, zum Beispiel aus einem Metallblech, geformt. Die Querbrücken können eine Beschichtung aufweisen. Die Metallbleche können an der Stirnseite des Leistungsphasenmoduls abgewinkelte Bereiche aufweisen und zu DC-Anschlüssen ausgeformt sein.

Gemäß einer Ausführungsform sind das erste DC-Anschlusspaar und das erste DC-Kondensator-Anschlusspaar aus von Querbrücken abgewinkelten Metallblechbereichen gebildet und diese Metallblechbereiche im Wesentlichen in einer Ebene angeordnet sind, wobei die jeweiligen Verbindungselemente des ersten DC-Anschlusspaars und des ersten DC-Kondensator-Anschlusspaars an oder in den abgewinkelten Metallblechbereichen ausgebildet sind.

Gemäß einer Ausführungsform ist das DC-Kondensator-Anschlusspaar derart an der Stirnseite ausgebildet, dass ein Verschieben des Leistungsphasenmoduls mit der Stirnseite voran einen Kontakt zwischen dem DC-Kondensator-Anschlusspaar und einem an der Stirnseite platziertem Zwischenkreiskondensatormodul herstellt. Das Leistungsphasenmodul kann mit seiner Stirnseite voran auf Anschlüsse des Zwischenkreiskondensatormoduls geschoben werden. Dazu kann das Leistungsphasenmodul verschiebbar so gelagert sein, dass die Stirnseite im Wesentlichen vertikal orientiert ist. Das Leistungsphasenmodul kann dazu Halterungen, zum Beispiel Führungsschienen, aufweisen. Bei diesem Verschieben kann ebenso die Kühlvorrichtung mit einem dafür vorgesehenen Anschluss eines Kühlmittelsystems verbunden werden.

Mehrere Leistungsphasenmodule können gemäß einer Ausführungsform nebeneinander derart angeordnet werden, sodass ihre Stirnseiten jeweils im Wesentlichen vertikal orientiert sind. Insbesondere können die Stirnseiten der mehreren Leistungsphasenmodule parallel zueinander und/oder in einer Ebene und/oder die Leistungsphasenmodule in dieselbe Richtung weisend angeordnet sein.

Das Leistungsphasenmodul ist gemäß einer Ausführungsform als Bestandteil eines modularen Umrichters ausgebildet. Es kann insbesondere austauschbar und lösbar befestigbar in dem Umrichter eingebaut werden. Die Gesamtmasse des Leistungsphasenmoduls beträgt weniger als 50kg, insbesondere weniger als 30kg. Dadurch kann das Leistungsphasenmodul ohne mechanische Hebevorrichtungen ein- und ausgebaut werden. Die Kondensatoren des Zwischenkreiskondensatormodules, die sich in einem Betriebszustand im Kommutierungskreis befinden, sind niederinduktiv an die Schaltvorrichtungen anschließbar.

Es wird weiterhin ein Umrichter mit mindestens zwei, insbesondere mindestens drei, Leistungsphasenmodulen vorgeschlagen. Der Umrichter weist mindestens zwei, insbesondere mindestens drei, Zwischenkreiskondensatormodule auf, wobei jedes Leistungsphasenmodul mit seiner Stirnseite auf einem ihm zugeordneten Zwischenkreiskondensatormodul angeordnet ist, und wobei das erste DC-Kondensator-Anschlusspaar jedes Leistungsphasenmodules mit korrespondierenden Kontaktelementen des zugeordneten Zwischenkreiskondensatormodules lösbar verbunden ist.

Durch das Verwenden mehrere Zwischenkreiskondensatormodule in einem Umrichter und das Platzieren nah an den Leistungsphasenmodulen, bzw. den Schaltvorrichtungen, wird die Induktivität der Verbindungen verringert. Die Kondensatoren in den Zwischenkreiskondensatormodulen werden weniger belastet, und deren Lebenszeit wird verlängert.

Jedes Zwischenkreiskondensatormodul ist einem Leistungsphasenmodul zugeordnet und an dieses durch Verbindungselemente angeschlossen. Das Zwischenkreiskondensatormodul weist dazu korrespondierende Kontaktelemente auf.

Gemäß einer Ausführungsform weist der Umrichter weiterhin ein Stromschienenpaar mit einer ersten Stromschiene und einer parallel zur ersten Stromschiene verlaufenden zweiten Stromschiene zum Führen eines Gleichstroms auf. Die erste Stromschiene und die zweite Stromschiene liegen im Wesentlichen in einer Ebene und die Leistungsphasenmodule mit ihren Stirnseiten sind nebeneinander und parallel zu dieser Ebene angeordnet, wobei das erste DC-Anschlusspaar jedes Leistungsphasenmodules über seine Verbindungselemente an die erste Stromschiene und an die zweite Stromschiene angeschlossen ist. Über die Stromschiene sind die Leistungsphasenmodule ebenso mit weiteren Zwischenkreiskondensatormodulen verbunden, diese Verbindungen weisen aber einen größeren Ohm'schen Widerstand und eine größere Induktivität auf als die direkte Verbindung zu dem, dem Leistungsphasenmodul zugeordneten, Zwischenkreiskondensatormodul.

Gemäß einer Ausführungsform weist der Umrichter weiterhin ein Verbinderpaar mit einem ersten Verbinder und einem zweiten Verbinder auf, wobei der erste Verbinder und der zweite Verbinder im Wesentlichen in einer Ebene liegen und die Leistungsphasenmodule mit ihren Stirnseiten nebeneinander und parallel zu dieser Ebene angeordnet sind, und wobei das erste DC-Kondensator-Anschlusspaar jedes Leistungsphasenmodules über seine Verbindungselemente an einen ersten Verbinder und einen zweiten Verbinder angeschlossen ist. Die Verbindungselemente des ersten DC-Kondensator-Anschlusspaares können dazu mit korrespondierenden Kontaktelementen der Zwischenkreiskondensatormodule und mit den ersten und zweiten Verbindern verbunden sein.

Gemäß einer Weiterentwicklung der Ausführungsform weist der Umrichter weiterhin ein zweites Stromschienenpaar mit einer dritten Stromschiene und einer vierten Stromschiene zum Führen eines Gleichstroms auf. Die erste Stromschiene, die zweite Stromschiene, die dritte Stromschiene und die vierte Stromschiene können abschnittsweise parallel verlaufen und im Wesentlichen in einer Ebene liegen, und wobei die Anschlüsse der zweiten DC-Anschlusspaare an die dritte Stromschiene und an die vierte Stromschiene anschließbar sind.

Gemäß einer Weiterentwicklung der Ausführungsform weist der Umrichter weiterhin ein zweites Verbinderpaar mit einem dritten Verbinder und einem vierten Verbinder auf, wobei der dritte Verbinder und der vierte Verbinder im Wesentlichen in einer Ebene liegen und die Leistungsphasenmodule mit ihren Stirnseiten nebeneinander und parallel zu dieser Ebene angeordnet sind, und wobei das zweite DC-Kondensator-Anschlusspaar jedes Leistungsphasenmodules über seine Verbindungselemente an den dritten Verbinder und den vierten Verbinder angeschlossen ist. Die Verbindungselemente des zweiten DC-Kondensator-Anschlusspaares können dazu mit korrespondierenden Kontaktelementen der Zwischenkreiskondensatormodule und mit den dritten und vierten Verbindern verbunden sein.

Gemäß einer Ausführungsform liegen die erste, zweite, dritte und vierte Stromschienen und der erste, zweite, dritte und vierte Verbinder in einer Ebene.

Gemäß einer Ausführungsform sind Stromschienen paarweise, abschnittsweise parallel ausgebildet. Sie können mechanisch miteinander verbunden aber elektrisch voneinander isoliert sein, beispielsweise durch ein festes Isolationsmaterial. Die Isolation kann beispielsweise aus einem Kunststoff geformt sein. Die elektrische Leitfähigkeit und die Dicke der Isolation sind derart ausgelegt, dass zwischen den Stromschienen eine Spannung von mehr als 500V, insbesondere 600V bis etwa 4500V, angelegt werden kann.

Gemäß einer Ausführungsform bilden die ersten DC-Anschlusspaare benachbarter Leistungsphasenmodule zusammen mit dem ersten Stromschienenpaar eine hochinduktive, niederohmige Parallelschaltung zwischen benachbarten Leistungsphasenmodulen, und die das Verbinderpaar bildet zusammen eine niederinduktive, hochohmige Verbindung zwischen benachbarten Zwischenkreiskondensatormodulen. Die Zwischenkreiskondensatormodule sind daher auf zwei Wegen elektrisch parallel geschaltet.

Die niederinduktiven, hochohmigen Verbindungen bestehen zwischen den Zwischenkreiskondensatormodulen. Es sind räumlich kurze und direkte Verbindungen im Vergleich zu den hochinduktiven, niederohmigen Verbindungen, die über die Leistungsphasenmodule laufen.

Gemäß einer Ausführungsform sind die erste und zweite Querbrücke ein Teil der hochinduktiven, niederohmigen Verbindungen. Dabei erstreckt sich eine hochinduktive, niederohmige Verbindung von einem Zwischenkreiskondensatormodul über einen Anschluss des DC-Kondensator-Anschlusspaares über eine der Querbrücken, über einen Anschluss des DC-Anschlusspaares, aus dem Zwischenkreiskondensatormodul zugeordnetem Leistungsphasenmodul heraus über eine der Stromschienen in ein benachbartes Leistungsphasenmodul, über einen Anschluss des DC-Anschlusspaares, über eine der Querbrücken, über einen Anschluss des DC-Kondensator-Anschlusspaares in das benachbarte Zwischenkreiskondensatormodul.

Eine hochinduktive, niederohmige Parallelschaltung zwischen benachbarten Zwischenkreiskondensatormodulen besteht aus zwei hochinduktiven, niederohmigen Verbindungen.

Die niederinduktiven, hochohmigen Verbindungen werden zwischen den Zwischenkreiskondensatormodulen durch die Verbinder gebildet. Die Verbinder können aus Metallblechen, beispielsweise aus einem Stahlblech bestehen. Sie können einstückig über mehrere Zwischenkreiskondensatormodule verlaufen oder aus einzelnen Abschnitten zusammengesetzt sein.

Eine niederinduktive, hochohmige Parallelschaltung zwischen benachbarten Zwischenkreiskondensatormodulen besteht aus zwei niederinduktiven, hochohmigen Verbindungen.

Gemäß einer Ausführungsform weisen die Verbinder in einem Bereich zwischen zwei Zwischenkreiskondensatormodulen einen höheren Ohm'schen Widerstandswert auf als unmittelbar an den Zwischenkreiskondensatormodulen. Beispielsweise kann das einen kleineren Querschnitt des leitenden Materials, zum Beispiel eines Metallbleches, umfassen. Ein kleinerer Querschnitt kann durch Aussparungen im leitenden Material erzeugt werden. Ein erhöhter Ohm'scher Widerstand an dieser Stelle führt dazu, dass elektrische Energie dort gezielt in Wärme umgewandelt wird. Im regulären Betrieb werden dadurch parasitäre Schwingströme gezielt in den niederinduktiven, hochohmigen Verbindungen in Wärme umgesetzt und vorteilhaft gedämpft. Bei einem Kurzschluss entsteht gezielt in den Verbindern zwischen den Zwischenkreiskondensatormodulen Wärme und die elektrische Energie wird dadurch unschädlich gemacht. Elektronische Bauteile in der Nähe, wie die Zwischenkreiskondensatormodule, werden von hohen Strömen und Hitzeentwicklung verschont.

Gemäß einer Ausführungsform weisen die Verbinder eine mindestens um den Faktor 2, insbesondere mindestens um den Faktor 5, höhere Induktivität auf als die parallel dazu verlaufende hochohmigen, niederinduktiven Verbindungen über die Stromschienen und die Querbrücken. Beispielsweise liegt die Induktivität der niederohmigen, hochinduktiven Verbindungen zwischen zwei Zwischenkreiskondensatormodulen im Bereich von 100nH bis 300nH und die Induktivität der hochohmigen, niederinduktiven Verbindungen im Bereich von 10nH bis 30nH. Die Angaben beziehen sich auf einen Betriebszustand mit dem dazugehörigen fließenden Strom von einigen hundert Ampere.

Da der Umrichter und insbesondere das Leistungsphasenmodul für sehr hohe Ströme ausgelegt ist, stellt die Anordnung einen sehr schwach gedämpften C-L-C-L-Kettenleiter dar. Durch die eingeprägten Ströme der Schaltvorrichtungen werden Schwingströme angeregt. Durch diese Schwingströme erhöht sich der Effektivwert des Stroms in den Zwischenkreiskondensatormodulen.

Gemäß einer Ausführungsform bildet die modulare Zwischenkreisschaltung einen C-L-C-L-Kettenleiter mit dem L-Glied mit der Induktivität L der ersten niederohmigen, hochinduktiven Verbindungen oder der zweiten niederohmigen, hochinduktiven Verbindungen und dem C-Glied mit der Kapazität C des Zwischenkreiskondensatormodules, wobei das L-Glied und das C-Glied einen L-C-Schwingkreis bilden und die erste hochohmige, niederinduktive Verbindung oder die zweite hochohmige, niederinduktive Verbindung zusätzlich parallel zum L-Glied des L-C-Schwingkreises geschaltet ist.

Während Gleichstrom und der niederfrequente AC-Anteil durch die niederohmigen, hochinduktiven Verbindungen fließen, werden höher frequentierte AC-Anteile durch die mit weniger Induktivität aber mit höheren Ohm'schen Widerstand behafteten niederinduktiven, hochohmigen Verbindungen zwischen den Zwischenkreiskondensatormodulen geleitet und dabei gedämpft. Dadurch verringern sich die Effektivströme in den niederohmigen, hochinduktiven Verbindungen und in den Zwischenkreiskondensatoren.

Im Falle eines Kurzschlusses in einem Leistungsphasenmodul wird der oder werden die Kondensatoren des dazugehörigen Zwischenkreiskondensatormodules sehr schnell entladen. Die anderen Kondensatoren umliegender Zwischenkreiskondensatormodule speisen über die Stromschienen und die Verbinder auf den Kurzschluss ein. Die Verbinder zwischen den Zwischenkreiskondensatormodulen bewirken durch ihren Ohm'schen Widerstand ein rasches Abklingen der durch den Kurzschluss verursachten Schwingungen. Ein Großteil der Kurzschlussenergie wird in den Verbindern in Wärme umgesetzt und dadurch unschädlich gemacht. Die anderen Leistungsphasenmodule und Zwischenkreiskondensatormodule können dadurch vor Zerstörung geschützt werden.

Gemäß einer Ausführungsform weist das Leistungsphasenmodul sowohl einen erstes als auch ein zweites DC-Anschlusspaar und sowohl ein erstes als auch ein zweites DC-Kondensator-Anschlusspaar auf. Weiterhin weist der Umrichter sowohl einen erstes als auch ein zweites Stromschienenpaar und sowohl ein erstes als auch ein zweites Verbinderpaar auf. Das erste DC-Anschlusspaar benachbarter Leistungsphasenmodule bildet zusammen mit dem ersten Stromschienenpaar eine hochinduktive, niederohmige Parallelschaltung zwischen benachbarten Zwischenkreiskondensatormodulen, und das erste Verbinderpaar bildet eine niederinduktive, hochohmige Verbindung zwischen benachbarten Leistungsphasenmodulen. Analog bildet das zweite DC-Anschlusspaar benachbarter Leistungsphasenmodule zusammen mit dem zweiten Stromschienenpaar dabei eine zweite hochinduktive, niederohmige Verbindung zwischen benachbarten Zwischenkreiskondensatormodulen, und das zweite Verbinderpaar bildet eine zweite niederinduktive, hochohmige Parallelschaltung zwischen benachbarten Leistungsphasenmodulen.

Dabei entsteht eine Symmetrie, wodurch stromdurchflossene Leiter, also Stromschienen und Verbinder, mit jeweils einen dazugehörigem zweiten Leiter entgegengesetzter Stromrichtungen nah aneinander geführt werden können. In diesem Aufbau wird die Induktivität durch Minimierung von Leiterschleifengrößen optimiert.

Gemäß einer Ausführungsform wird ein Fahrzeug, insbesondere ein Schienenfahrzeug, mit einem Energiewandler zum Umwandeln von elektrischer Energie in Bewegungsenergie oder umgekehrt und einem Umrichter vorgeschlagen, wobei mindestens ein AC-Anschluss eines Leistungsphasenmoduls mit dem Energiewandler verbunden ist.

Mit dem vom Umrichter erzeugten Wechselstrom kann beispielsweise ein Elektromotor zum Antrieb des Fahrzeuges angetrieben werden. Ebenso kann die Boardelektronik mit Strom versorgt werden. Die Frequenz und Spannung an dem oder den AC-Ausgängen kann an die Nutzung im Fahrzeug angepasst werden.

Ebenso kann ein Energiewandler als Dynamo / Generator wirken, beispielsweise bei einem Bremsvorgang. Die elektrische Energie wird dann vom Dynamo aus mechanischer Energie erzeugt und an den Umrichter geleitet. Dieser wandelt den Wechselstrom in einen Gleichstrom.

Als Schienenfahrzeuge werden insbesondere Züge, U-Bahnen, Metros, Straßenbahnen, Hochgeschwindigkeitszüge oder ähnliche angesehen.

Figuren

Die beiliegenden Zeichnungen veranschaulichen Ausführungsformen und dienen zusammen mit der Beschreibung der Erläuterung der Prinzipien der Erfindung. Die Elemente der Zeichnungen sind relativ zueinander und nicht notwendigerweise maßstabsgetreu. Gleiche Bezugszeichen bezeichnen ähnliche Teile.

Figur 1 zeigt ein Leistungsphasenmodul gemäß einer Ausführungsform.

Figur 2 zeigt das Leistungsphasenmodul gemäß nach der Ausführungsform der Figur 1, wobei eine Querbrücke entfernt ist.

Figur 3 zeigt das Leistungsphasenmodul gemäß nach der Ausführungsform der Figur 1 mit angeschlossenem Zwischenkreiskondensatormodul.

Figur 4 zeigt einen Umrichter gemäß einer Ausführungsform.

Figur 5 zeigt eine Detailansicht von Stromschienen gemäß einer Ausführungsform.

Figur 6 zeigt eine schematische Darstellung der Anordnung des Umrichters.

Figur 7 zeigt ein Schaltplan gemäß einer Ausführungsform.

Figur 8 zeigt einen vereinfachten Schaltplan gemäß einer Ausführungsform.

Figur 9 zeigt ein vereinfachtes Ersatzschaltbild für einen Umrichter mit 8 Leistungsphasenmodulen.

Figur 10 zeigt ein Schienenfahrzeug gemäß einer Ausführungsform.

Ausführungsbeispiele

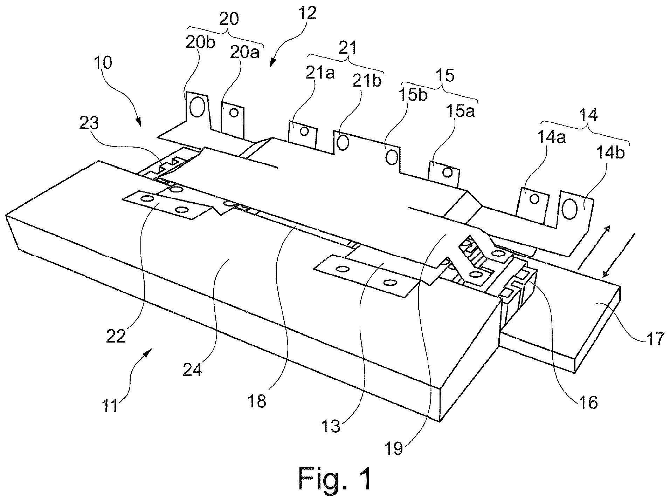

In Figur 1 ist eine Ausführungsform eines Leistungsphasenmoduls 10 dargestellt. Das Leistungsphasenmodul 10 hat in etwa die Form eines abgeflachten Quaders mit zwei großflächigen Seiten und vier kleinflächigen Seiten. Die kleinflächigen Seiten können Stirnseiten des Leistungsphasenmoduls 10 sein. An einer Stirnseite 12 des Leistungsphasenmoduls 10 sind ein erstes DC-Anschlusspaar 14 und ein zweites DC-Anschlusspaar 20 angeordnet. Weiterhin sind ein erstes DC-Kondensator-Anschlusspaar 15 und ein zweites DC-Kondensator-Anschlusspaar 21 an der Stirnseite 12 angeordnet.

An einer anderen Seite, in diesem Fall der gegenüberliegenden Stirnseite 11 des Leistungsphasenmoduls 10 ist ein erster AC-Anschluss 13 angeordnet. Ein zweiter AC-Anschluss 22 ist ebenfalls an der gegenüberliegenden Stirnseite 11 angeordnet.

Eine erste Schaltvorrichtung 16 ist mit dem ersten DC-Anschlusspaar 14 und mit dem ersten AC-Anschluss 13 verbunden. Die Schaltvorrichtung 16 ist auf einer Kühlvorrichtung 17 angeordnet, sodass die Kühlvorrichtung 17 entstehende Wärme aus der Schaltvorrichtung 16 und aus dem Leistungsphasenmodul 10 abführen kann.

Das Leistungsphasenmodul 10 weist weiterhin eine zweite Schaltvorrichtung 23 auf, die mit dem ersten DC-Anschlusspaar 14 und mit einem zweiten AC-Anschluss 22 verbunden ist. Sie ist neben der ersten Schaltvorrichtung 16 auf der Kühlvorrichtung 17 angeordnet. Die beiden Schaltvorrichtungen 16, 23 sind in einer Ebene senkrecht zur Stirnseite angeordnet.

Die DC-Kondensator-Anschlusspaare 15, 21 sind nebeneinander und zwischen den beiden DC-Anschlusspaaren 14, 20 angeordnet. Die DC-Kondensator-Anschlusspaare 15, 21 und die DC-Anschlusspaare 14, 20 sind in einer Ebene und in einer Reihe angeordnet.

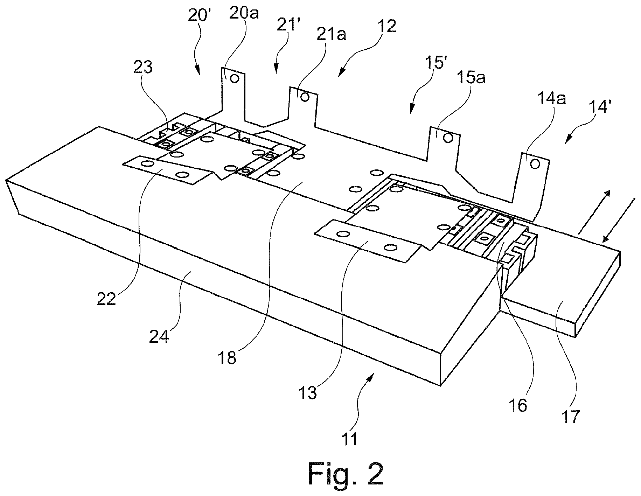

Die DC-Kondensator-Anschlusspaare 15, 21 und die DC-Anschlusspaare 14, 20 weisen jeweils einen ersten Anschluss 14a, 15a, 20a, 21a und einen zweiten Anschluss 14b, 15b, 20b, 21b auf. Verbindungelemente sind an in beziehungsweise an den Anschlüssen angeordnet. Die ersten Anschlüsse 14a, 15a, 20a, 21a sind über eine erste Querbrücke 18 miteinander verbunden. Die zweiten Anschlüsse 14b, 15b, 20b, 21b sind über eine zweite Querbrücke 19 miteinander verbunden. Details der zweiten Querbrücke 19 werden in Figur 1 verdeckt. Diese sind in Figur 2 illustriert, die eine Ausführungsform des Leistungsphasenmoduls 10 zeigt, bei der keine zweite Querbrücke 19 dargestellt ist.

Die ersten Anschlüsse 14a, 15a, 20a, 21a sind einstückig mit der ersten Querbrücke 18 geformt. Die erste Querbrücke 18 weist ein Metallblech auf. Abgewinkelte Bereiche der Metallbleche bilden die ersten Anschlüssen 14a, 15a, 20a, 21a zum Anschließen an Stromschienen. Die Verbindungselemente sind als Bohrlöcher für beispielsweise eine Schraubverbindung ausgeführt. Die ersten Anschlüsse 14a, 15a, 20a, 21a können auch mehrstückig, d.h. aus mehreren Teilen zusammengesetzt sein. Analog aber nicht zwangsweise identisch in einer Ausführungsform gilt das für die zweite Querbrücke 19 und die zweiten Anschlüsse 14b, 15b, 20b, 21b. Die erste Querbrücke 18 und die zweite Querbrücke 19 können unterschiedlich ausgebildet sein und sich beispielsweise durch eine Einstückigkeit, durch unterschiedliche Materialien oder Beschichtungen unterscheiden.

Die erste Querbrücke 18 verbindet den ersten Anschluss 14a des ersten DC-Anschlusspaares 14 mit der ersten Schaltvorrichtung 16. Die zweite Querbrücke 19 verbindet den zweiten Anschluss 14b des ersten DC-Anschlusspaares 14 mit der ersten Schaltvorrichtung 16. Dadurch fließt der Gleichstrom vom ersten DC-Anschlusspaar 14 über die Querbrücken 18, 19 in die Schaltvorrichtung 16 und wird dort umgewandelt. Der erzeugte Wechselstrom kann am ersten AC-Anschluss 13 abgegriffen werden. Umgekehrt kann auch ein Wechselstrom in einen Gleichstrom umgewandelt werden.

Die erste und zweite Querbrücke 18, 19 verlaufen unmittelbar nebeneinander und abschnittsweise parallel. Sie sind räumlich nah aneinander und elektrisch voneinander isoliert und für hohe Spannungen von über 500V, insbesondere Spannung zwischen etwa 600V und 4500V, und hohe Ströme von mehr als 100A, insbesondere für Ströme von 100A bis 1000A, ausgelegt. Beispielsweise kann der Strom bei einem Dual-Schaltmodul bei 500A und bei einem Einzel-Schaltmodul bei 800A liegen. Durch eine maximale Leistung in einem Betriebszustand kann die angelegte Spannung den Stromfluss begrenzen.

Eine Querbrücke 18, 19 in dieser Ausführungsform hat eine großflächigen Metallblechbereich und mindestens zwei davon abgewinkelte Bereiche. Über die Querbrücken 18, 19 fließt in einem Betriebszustand ein hoher Strom von mehreren hundert Ampere. Das Material und die Dicke der Querbrücken 18, 19 müssen daher entsprechend dieser Strombelastung angepasst sein.

Der großflächige Metallblechbereich der Querbrücken 18, 19 kann im Wesentlichen parallel zu den großflächigen Seiten des Leistungsphasenmoduls. Die Querbrücken 18, 19 können daher quer, also im Wesentlichen senkrecht, zu dem Verlauf angeschlossener Stromschienen angeordnet sein.

Beispielsweise kann die Kühlvorrichtung 17 an oder entlang einer der großflächigen Seiten des Leistungsphasenmoduls angeordnet sein oder diese bilden. Die Schaltvorrichtung 16 kann auf der Kühlvorrichtung 17 angeordnet sein. Die Kühlvorrichtung 17 kann auf einer Seite der Schaltvorrichtung 16 und die Querbrücken 18, 19 auf einer dazu gegenüberliegenden Seite der Schaltvorrichtung 16 angeordnet sein.

Die Schaltvorrichtungen 16, 23 weisen in dieser Ausführungsform ein Dual-Schaltmodul auf und sind daher sowohl mit der ersten Querbrücke 18 als auch mit der zweiten Querbrücke 19 verbunden. Dual-Schaltmodule sind elektrisch als Zweiweg-Gleichrichter aufgebaut und können beide Potentiale der beiden Querbrücken 18, 19 für die Wechselstromphase umwandeln.

In einem Betriebszustand kann jede Schaltvorrichtung 16, 23 unabhängig voneinander durch eine Steuerung 24, insbesondere einer Gatesteuerung, als Zweiweg-Gleichrichter betrieben werden und einen Wechselstrom am jeweiligen AC-Anschluss 13, 22 erzeugen. Die Schaltvorrichtungen weisen insbesondere steuerbare Halbleiterelemente auf. Das können Halbleiterelemente mit steuerbaren Gate-Elektroden sein. Die Steuerung 24 steuert dann die Gatespannungen an den Gateelektroden und dadurch den Stromfluss durch die Halbleiterelemente, bzw. die Schaltvorrichtung 16, 23. Insbesondere können die Halbleiterelemente IGBTs sein und die Steuerung umfasst die Gatesteuerung 24 der Gates der IGBTs.

Die Steuerung 24 kann, gemäß einer Ausführungsform, an einer zu den Anschlusspaaren des Leistungsphasenmoduls gegenüberliegenden Stirnseite angeordnet sein, die auch als zweite oder hintere Stirnseite bezeichnet werden kann.

Gemäß einer Ausführungsform kann die Steuerung 24 mechanisch von der Kühlvorrichtung 17 oder den Schaltvorrichtungen 16, 23 oder beiden getragen werden.

Das Leistungsphasenmodul 10 in Figur 1 weist zwei DC-Kondensator-Anschlusspaare 15, 21 auf. Dabei sind die Anschlüsse 15a, 15b, 21a, 21b so in einer Reihe angeordnet, dass in einem Betriebszustand die beiden zweiten Anschlüsse 15b, 21b auf einem Potential liegen und von außen von den ersten Anschlüssen 15a, 21a auf einem anderen Potential umschlossen sind. Es entsteht eine Spiegelsymmetrie der Anschlüsse und damit der Potentiale. In dieser Ausführungsform erhalten die Anschlüsse der beiden DC-Anschlusspaare 14, 20 die Spiegelsymmetrie ebenso. Die ersten Anschlüsse 14a, 15a, 20a, 21a und zweiten Anschlüsse 14b, 15b, 20b, 21b können auch jeweils mit dem dazugehörigen Anschluss des jeweiligen Paares vertauscht sein. Die Spiegelsymmetrie bleibt dabei erhalten. Die Symmetrie hat den Vorteil, dass die Impedanz an den Anschlüssen für beide Stromrichtungen jeweils identisch oder nahezu identisch ist. Dadurch wird ein gleichmäßiger Stromfluss möglich.

Die DC-Anschlüsse 14a, 15a, 20a, 21a, 14b, 15b, 20b, 21b können zum Anschließen an Stromschienen oder an ein Zwischenkreiskondensatormodul Verbindungselemente zum elektrischen Verbinden und/oder ein Befestigungsmittel zum mechanischen Befestigen aufweisen. In diesem Ausführungsbeispiel sind Löcher zum Einführen eines korrespondierenden Kontaktelementes und/oder eines Befestigungsmittels vorgesehen.

Die Verbindungselemente der DC-Kondensatoranschlüsse 21, 15 können anders als die Verbindungselemente der DC-Anschlusspaare 14, 20 ausgebildet sein. Beispielsweise können Bohrlochgrößen variieren oder es können komplett unterschiedliche Verbindungselemente verwendet werden. Der Abstand des ersten Anschlusses 14a, 15a, 20a, 21a zum zweiten Anschluss 14b, 15b, 20b, 21b kann bei dem oder den DC-Kondensator-Anschlusspaaren 15, 21 ebenso unterschiedlich groß sein als bei dem oder den DC-Anschlusspaaren 14, 20. Die DC-Kondensator-Anschlusspaaren 15, 21 werden an Verbinder und Zwischenkreiskondensatormodule und die DC-Anschlusspaaren 14, 20 an Stromschienen angeschlossen.

Das Leistungsphasenmodul 10 weißt in Figur 1 eine Gatesteuerung 24 auf. Die Gatesteuerung 24 ist mit den Schaltvorrichtungen 16, 23 verbunden. Sie steuert die Schaltvorrichtungen 16, 23 in derart, dass eine anliegende Gleichspannung an der Schaltvorrichtung 16, 23 in eine Wechselspannung oder umgekehrt umgewandelt wird. Die Schaltvorrichtung kann dabei insbesondere IGBTs mit einem steuerbaren Gate aufweisen.

Die Gatesteuerung 24 gibt eine Frequenz vor, in der die Schaltvorrichtungen 16, 23 so gesteuert werden, dass eine Wechselspannung mit der korrespondierenden Frequenz an den jeweiligen AC-Ausgängen 13, 22 erzeugt wird. Die Frequenzen und/oder der Spannungsverlauf der AC-Ausgänge kann unterschiedlich sein. Insbesondere können die Wechselspannungen aufeinander abgestimmt sein, sodass unterschiedliche Phaseneingänge eines Elektromotors mit unterschiedlichen AC-Ausgängen 13, 22 gespeist werden können.

Die Kühlvorrichtung 17 kann Hydraulikanschlüsse zum Führen von Kühlmittel in die und aus der Kühlvorrichtung 17 aufweisen. Die Hydraulikanschlüsse sind vorteilhaft an der Stirnseite 12 angeordnet, sodass bei einem Anschließen durch ein Aufschieben des Leistungsphasenmodules 10 auf die Stromschienenpaare und das Zwischenkreiskondensatormodul ebenfalls die Kühlvorrichtung mit ihren Hydraulikanschlüssen an ein Kühlmittelführungssystem angeschlossen wird.

Figur 2 zeigt die Ausführungsform des Leistungsphasenmodules 10 der Figur 1 ohne die zweite Querbrücke 19 und die ersten Anschlüsse 14b, 15b, 20b, 21b, der DC-Kondensator-Anschlusspaare 15', 21' und der DC-Anschlusspaare 14', 20'.

In Figur 1 verdeckte die zweite Querbrücke 19, dass die Schaltvorrichtung 16 mit der ersten Querbrücke 18 verbunden ist. Ebenso ist die Schaltvorrichtung 16 mit ihrem dazugehörigen AC-Anschluss 13 verbunden.

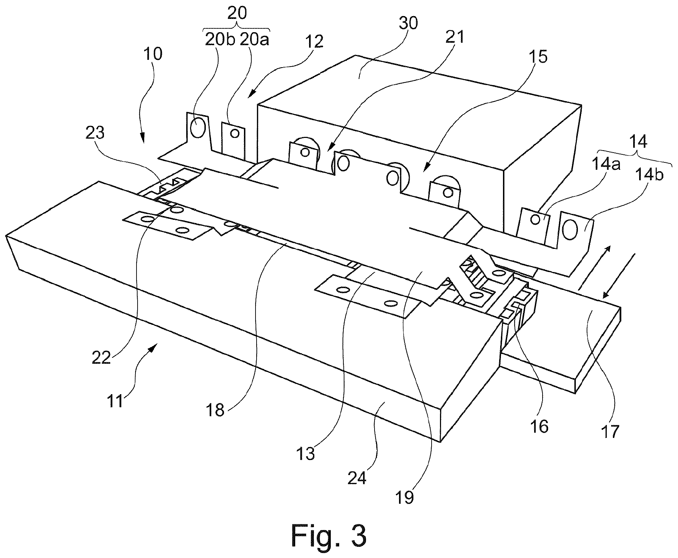

Figur 3 zeigt ein Leistungsphasenmodul 10 mit angeschlossenem Zwischenkreiskondensatormodul 30. Das Zwischenkreiskondensatormodul 30 weist vier Anschlüsse auf und ist daher sowohl an das erste DC-Kondensator-Anschlusspaar 15 also auch an das zweite DC-Kondensator-Anschlusspaar 21 angeschlossen.

Die Schaltvorrichtungen 16, 23 sind in dieser Ausführungsform mit jeweils zwei Kontaktpunkten mit den Querbrücken 18, 19 kontaktiert. Jede Schaltvorrichtung ist als Dual-Schaltmodul ausgebildet und weist zwei Halbbrücken auf, wobei jede Halbbrücke mit einem Kontaktpunkt mit den Querbrücken kontaktiert ist.

Das Zwischenkreiskondensatormodul 30 weist mindestens einen Kondensator auf, der als Zwischenkreiskondensator geeignet ist. Die Querbrücken 18, 19 sind zusammen mit dem Kondensator des Zwischenkreiskondensatormodules 30 Teil des Zwischenkreis in einem Betriebszustand des Leistungsphasenmoduls 10 beziehungsweise des Umrichters. Dabei ist der Zwischenkreiskondensator Teil des Kommutierungskreises, also dem Stromkreis, bei dem sich bei einem Schaltvorgang der Schaltvorrichtung 16, 23 der Strom ändert. Der Zwischenkreiskondensator des Zwischenkreiskondensatormoduls 30 wird daher auch Kommutierungskondensator genannt.

Die elektrische Verbindung zwischen Schaltvorrichtungen 16, 23 und Zwischenkreiskondensatormodul 30 ist niederinduktiv. Dies wird durch den kompakten Aufbau des Leistungsphasenmoduls 10 erreicht. Das Zwischenkreiskondensatormodul 30 ist räumlich nah und damit niederinduktiv an die Schaltvorrichtungen 16, 23 angebunden. Zusätzlich sind die Querbrücken 18, 19 nah aneinander beziehungsweise übereinander angeordnet. Dadurch überlappen sich die Strompfade in den Querbrücken 18, 19 zwischen Schaltvorrichtung 16, 23, Zwischenkreiskondensatormodul 30 und DC-Anschlusspaaren 14, 20 optimal und die Induktivität des Leistungsphasenmoduls 10 wird verringert.

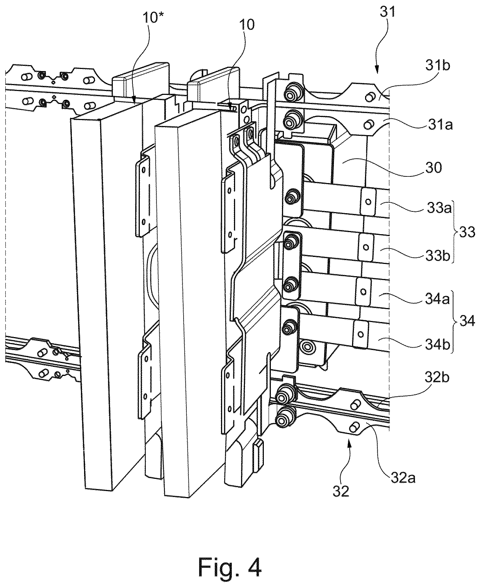

Die Figur 4 zeigt einen Umrichter nach einer Ausführungsform mit zwei Leistungsphasenmodulen 10, 10*. Aus Gründen der Übersichtlichkeit sind nur zwei Leistungsphasenmodule 10, 10* dargestellt. Es können noch weitere Leistungsphasenmodule entsprechend der Ausrichtung der beiden gezeigten neben den anderen angeordnet werden. Die Leistungsphasenmodule 10, 10* sind nebeneinander so angeordnet, dass ihre Stirnseiten in dieselbe Richtung zeigen.

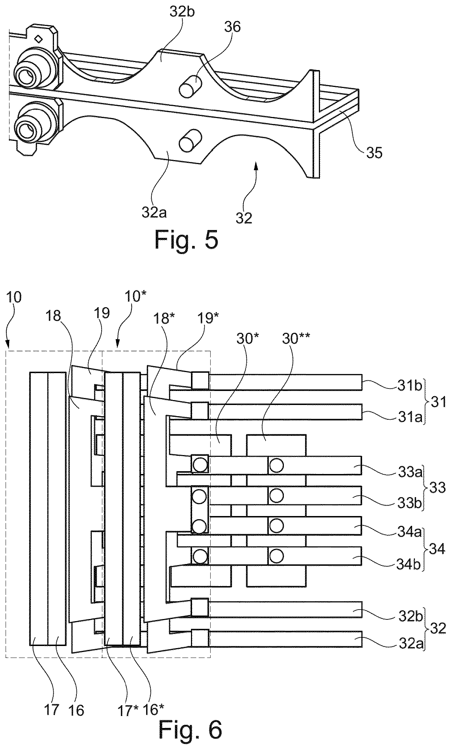

Die DC-Anschlusspaare sind jeweils an Stromschienenpaare 31, 32 angeschlossen, die hinter den Stirnseiten der Leistungsphasenmodule 10, 10* verlaufen. Die Stromschienenpaare 31, 32 weisen eine erste Stromschiene 31a eine zweite Stromschiene 31b, eine dritte Stromschiene 32a, und eine vierte Stromschiene 32a auf. Eine Detailansicht eines Stromschienenpaares 32 ist in Figur 5 gezeigt.

Jedem Leistungsphasenmodul 10, 10* ist ein Zwischenkreiskondensatormodul 30, 30* zugeordnet und jedes Leistungsphasenmodul 10, 10* ist an seinen DC-Kondensator-Anschlusspaaren mit dem zugeordnetem Zwischenkreiskondensatormodul 30, 30* verbunden. In der Darstellung der Figur 4 ist das zweite Zwischenkreiskondensatormodul 30* nicht sichtbar, da es hinter dem Leistungsphasenmodul 10* an deren Stirnseite angeordnet ist. Die Verbindung wird über Verbindungselemente elektrisch und mechanisch hergestellt. Die Verbindungselemente mit den korrespondierenden Kontaktelementen sind Löcher beziehungsweise Muttern und Schrauben.

Die Stromschienenpaare 31, 32 verlaufen im Wesentlichen parallel zueinander und so voneinander beabstandet, dass das Zwischenkreiskondensatormodul 30 zwischen den Stromschienenpaaren 31, 32 platziert werden kann. Die Anschlüsse der Stromschienenpaare 31, 32 und die Anschlüsse des Zwischenkreiskondensatormoduls 30 sind dann in einer Ebene und in einer Reihe angeordnet, sodass das Leistungsphasenmodul mit seiner Stirnseite voran an diese Ebene geschoben werden und angeschlossen werden kann.

Der Umrichter weist Verbinderpaare 33, 34 auf. Der erste Verbinder 33a, der zweite Verbinder 33b, der dritte Verbinder 34a, und der vierte Verbinder 34b verbinden die Zwischenkreiskondensatormodule 30 mit einander elektrisch. Abhängig von der Anzahl der Anschlüsse der Zwischenkreiskondensatormodule 30 beziehungsweise der Anzahl der DC-Kondensator-Anschlusspaare der Leistungsphasenmodule 10, 10* kann die Anzahl der Verbinder 33a, 33b, 34a, 34b variieren. Vorteilhaft ist die Anzahl der Verbinder 33a, 33b, 34a, 34b identisch mit der Anzahl der Anschlüsse der DC-Kondensator-Anschlusspaare, sodass alle Anschlüsse verbunden werden können. Die Verbinder 33a, 33b, 34a, 34b verbinden die Zwischenkreiskondensatormodule 30, sodass diese parallel geschaltet sind.

Bei einem Umrichter mit Verbindern 33a, 33b, 34a, 34b sind gemäß einer Ausführungsform sowohl die Zwischenkreiskondensatormodule 30, 30* als auch die Schaltvorrichtungen 16, 16* in den Leistungsphasenmodulen 10, 10* parallel geschaltet. Zusätzlich zu der Parallelschaltung durch die Verbinder 33a, 33b, 34a, 34b sind die Schaltvorrichtungen 16, 16* und die Zwischenkreiskondensatormodule 30, 30* durch die Stromschienen 31a, 31b, 32a, 32b und die Querbrücken 18, 19, 18*, 19* parallel geschaltet. Diese zweite Parallelschaltung weist eine höhere Induktivität und einen geringen Ohm'schen Widerstand auf als die der Verbinder 33a, 33b, 34a, 34b. Elektrisch sind die Zwischenkreiskondensatormodule 30, 30* daher über einerseits zwei niederinduktive, hochohmige Verbindungen und anderseits über zwei hochinduktive, niederohmige Verbindungen parallel geschaltet sind.

Gemäß einer Ausführungsform weist das Material der Verbinder 33a, 33b, 34a, 34b einen größeren spezifischen Widerstand als das Material der Stromschienen 31a, 31b, 32a, 32b auf. Beispielsweise sind die Verbinder 33a, 33b, 34a, 34b im Wesentlichen aus einem Stahl geformt und die Stromschienen 31a, 31b, 32a, 32b sind im Wesentlichen aus Kupfer oder Aluminium geformt.

Die Verbinder 33a, 33b, 34a, 34b sind beispielsweise aus einem Metallblech geformt. Es kann abschnittsweise zusammengesetzt sein, sodass bei einem Ausbau eines Zwischenkreiskondensatormodules 30, 30* die Verbinder 33a, 33b, 34a, 34b nur an den Verbindungsstellen zum Zwischenkreiskondensatormodul 30, 30* ausgebaut werden müssen.

Die Figur 5 zeigt eine Detailansicht eines Stromschienenpaares 32 mit einer ersten Stromschiene 32a und einer zweiten Stromschiene 32b. Die Stromschienen sind durch eine Isolation 35 miteinander mechanisch verbunden und elektrisch voneinander isoliert. Die Isolation kann aus einem festen Material bestehen, beispielsweise aus einem Kunststoff.

Stromschienen können ein korrespondierendes Kontaktelement 36 zum Befestigen an dem Verbindungselement eines DC-Anschlusspaares aufweisen. In diesem Ausführungsbeispiel ist das korrespondierendes Kontaktelement ein Stift mit oder ohne Gewinde zum Befestigen von beispielsweise einer Mutter oder einer Klemme an einem DC-Anschlusspaar 14, 20.

Die Figur 6 zeigt eine vereinfachte, schematische Darstellung des Ausbaus eines modularen Umrichters. Für die Übersichtlichkeit sind nur zwei Leistungsphasenmodule 10, 10* eingezeichnet. Jedes Leistungsphasenmodul 10, 10* weist eine Schaltvorrichtung 16, 16* und eine Kühlvorrichtung 17, 17* auf. AC-Anschlüsse oder Steuervorrichtungen sind in dieser Darstellung nicht gezeigt.

Gemäß einer Ausführungsform weist das Leistungsphasenmodul mindestens eine Steuerung 24 zum Steuern der Schaltvorrichtung 16, 23 auf. Die Steuerung ist vorteilhaft an der anderen Stirnseite 11 angeordnet. Insbesondere kann die Steuerung eine Gatesteuerung 24 sein und das Steuern der Schaltvorrichtung 16, 23 über Gates in den Halbleiterkomponenten ausgeführt sein.

Die Leistungsphasenmodule 10, 10* sind an Stromschienenpaare 31, 32 angeschlossen. Zwischen den Stromschienenpaaren 31, 32 sind Zwischenkreiskondensatormodule (30), 30* angeordnet. Jedem Leistungsphasenmodul 10, 10* ist ein Zwischenkreiskondensatormodul (30), 30* zugeordnet aber in dieser Darstellung ist nur eines der beiden Zwischenkreiskondensatormodule (30), 30* erkennbar. Ein weiteres Zwischenkreiskondensatormodul 30** ist so angeordnet, dass ein weiteres Leistungsphasenmodul mit der gleichen Ausrichtung der beiden anderen Leistungsphasenmodule 10, 10* über ihm platziert werden könnte.

Die Zwischenkreiskondensatormodule sind über Verbinder 33a, 33b, 34a, 34b parallel geschaltet. Zusätzlich sind die Zwischenkreiskondensatormodule über die Querbrücken 18, 19, 18*, 19* und die Stromschienenpaare 31, 32 parallel geschaltet.

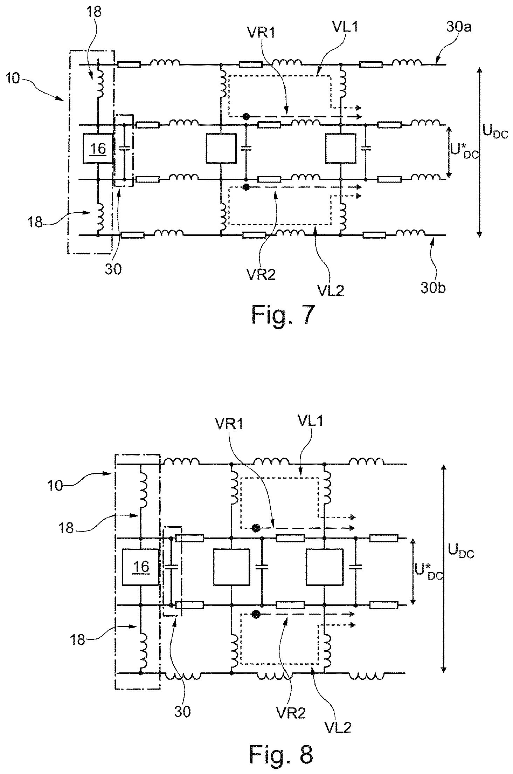

Die Figur 7 zeigt eine Ausführungsform der modularen Zwischenkreisschaltung. Es sind drei Zwischenkreiskondensatormodule 30 skizziert. Die Schaltvorrichtungen 16 sind parallel zu jeweils einem Zwischenkreiskondensatormodul 30 geschaltet. Zur Übersicht ist nur eine der Schaltvorrichtungen 16 und nur eines der Zwischenkreiskondensatormodule 30 mit Referenzzeichen versehen. Die drei gezeigten Schaltvorrichtungen 16 und die drei Zwischenkreiskondensatormodule 30 sind in dieser Ausführungsform identisch. Die Zwischenkreiskondensatormodule 30 weisen jeweils einen ersten Anschluss und einen zweiten Anschluss auf, wobei die ersten Anschlüsse zwei in der Kette jeweils unmittelbar aufeinanderfolgenden Zwischenkreiskondensatormodule 30 über eine erste niederohmige, hochinduktive Verbindung VL1 und eine erste hochohmige, niederinduktive Verbindung VR1 verbunden sind, die zweiten Anschlüsse zwei in der Kette jeweils unmittelbar aufeinanderfolgenden Zwischenkreiskondensatormodule 30 über eine zweite niederohmige, hochinduktive Verbindung VL2 und eine zweite hochohmige, niederinduktive Verbindung VR2 verbunden sind, die erste hochohmige, niederinduktive Verbindung VR1 parallel zu der zweiten hochohmigen, niederinduktiven Verbindung VR2 geschaltet ist, und die erste niederohmige, hochinduktive Verbindung VL1 parallel zu der zweiten niederohmigen, hochinduktiven Verbindung VL2 geschaltet ist.

Durch die erste niederohmige, hochinduktive Verbindung VL1 und die zweite niederohmige, hochinduktive Verbindung VL2 sind die zwei in der Kette jeweils unmittelbar aufeinanderfolgenden Zwischenkreiskondensatormodule 30 niederohmig und hochinduktiv parallelgeschaltet. Zusätzlich sind durch die erste hochohmige, niederinduktive Verbindung VR1 und die zweite hochohmige, niederinduktive Verbindung VR2 die zwei in der Kette jeweils unmittelbar aufeinanderfolgenden Zwischenkreiskondensatormodule 30 hochohmig und niederinduktiv parallel geschaltet.

Die Impedanzen der ersten niederohmigen, hochinduktiven Verbindung VL1 und der zweiten niederohmigen, hochinduktiven Verbindung VL2 sind identisch und die Impedanzen der ersten hochohmigen, niederinduktiven Verbindung VR1 und der zweiten hochohmigen, niederinduktiven Verbindung VR2 sind identisch. Die modulare Zwischenkreisschaltung weist daher eine Symmetrie auf, die einen symmetrischen Stromfluss in beide Stromrichtungen ermöglicht.

Die Zwischenkreiskondensatormodule 30 weisen in der Ausführungsform der Figur 7 jeweils einen Zwischenkreiskondensator auf. Die dargestellten Kondensatoren in der bilden daher jeweils ein Zwischenkreiskondensatormodul 30. Jeder Zwischenkreiskondensator weist einen ersten Anschluss und einen zweiten Anschluss auf und der erste Anschluss und der zweite Anschluss des Zwischenkreiskondensators bildet gleichzeitig den ersten Anschluss und den zweiten Anschluss des Zwischenkreiskondensatormodules. Alternativ können auch mehrere Zwischenkreiskondensatoren das Zwischenkreiskondensatormodul 30 bilden.

Realisiert werden kann können die niederohmigen, hochinduktiven Verbindungen VL1, VL2 beispielsweise durch parallele Stromschienen 30a, 30b und Querbrücken 18. In einem Betriebszustand liegt eine Gleichspannung $U_{DC}$ zwischen der oberen Stromschiene 30a und der unteren Stromschiene 30b an. Diese Gleichspannung $U_{DC}$ speist die Schaltvorrichtungen 16, die durch eine Steuervorrichtung eine Wechselspannung generieren. Die dazugehörigen Zwischenkreiskondensatoren in den Zwischenkreiskondensatormodulen 30 dienen als elektrischen Zwischenspeicher und Puffer. Zwischen dem ersten Anschluss und dem zweiten Anschluss der Zwischenkreiskondensatormodule 30 liegt eine Spannung $U_{DC}^{*}$ an. Die Schaltung der Zwischenkreiskondensatormodule 30 ist parallel und in einer Kette bezogen auf die zwischen dem ersten Anschluss und dem zweiten Anschluss des Zwischenkreiskondensatormodules 30 anliegende Gleichspannung $U_{DC}^{*}$.

Die niederohmigen, hochinduktiven Verbindungen VL1, VL2 sind durch gepunktete Linien dargestellt und enthalten jeweils drei Induktivitäten und einen Ohm'schen Widerstand. Die hochohmigen, niederinduktiven Verbindungen VR1, VR2 sind durch gestrichene Linien dargestellt und enthalten jeweils eine Induktivität und einen Ohm'schen Widerstand. Der Ohm'sche Widerstand in den hochohmigen, niederinduktiven Verbindungen VR1, VR2 ist dabei jeweils größer als der Ohm'sche Widerstand in den niederohmigen, hochinduktiven Verbindungen VL1, VL2.

Die eingezeichneten Induktivitäten und die Ohm'schen Widerstände in der Figur 7 sind wesentlich durch die Größen der Leiterschleifen, der Leitfähigkeit der Leiter und den Querschnitt des Leiters bestimmt. Da der Umrichter als Leistungsumrichter mit hohen Strömen ausgebildet ist, müssen die Leiter dementsprechend angepasst sein. Beispielsweise weisen die Leiter, die die niederohmigen, hochinduktiven Verbindungen VL1, VL2 bilden, ein Material mit hoher Leitfähigkeit, insbesondere Kupfer oder Aluminium, auf und die Leiter, die die hochohmigen, niederinduktiven Verbindungen VR1, VR2 bilden, weisen ein Material geringerer Leitfähigkeit, insbesondere Stahl, auf.

Die Figur 8 zeigt eine vereinfachte Darstellung der Schaltung von Figur 7. Die Ohm'schen Widerstände der niederohmigen, hochinduktiven Verbindungen VL1, VL2 und die Induktivitäten der hochohmigen, niederinduktiven Verbindungen VR1, VR2 sind nicht mehr eingezeichnet. In der Praxis sind Leiter ohne Ohm'schen Widerstand oder ohne Induktivität per se nicht möglich. Die Schaltung ist daher für den Fachmann so zu verstehen, dass die Leiter entweder durch ihre induktiven Eigenschaften oder ihre Ohm'schen Eigenschaften im Wesentlichen ausgezeichnet sind.

Da die Zwischenkreisschaltung für sehr hohe Ströme ausgelegt ist, würde die Anordnung ohne die hochohmigen, niederinduktiven Verbindungen VR1, VR2 einen sehr schwach gedämpften L-C-Kettenleiter darstellen. In der Darstellung der Figur 8 bildet die modulare Zwischenkreisschaltung einen L-C-Kettenleiter mit einem zusätzlichen R-Glied parallel zum L-Glied. Dabei ist die Induktivität der hochohmigen, niederinduktiven Verbindungen VR1, VR2 sowie der Ohm'sche Widerstand der niederohmigen, hochinduktiven Verbindungen VL1, VL2 vernachlässigt. Das L-Glied wird durch die Induktivität L der ersten niederohmigen, hochinduktiven Verbindungen VL1 und der zweiten niederohmigen, hochinduktiven Verbindungen VL2 und das C-Glied durch die Kapazität C des Zwischenkreiskondensatormodules 30 gebildet, wobei das L-Glied und das C-Glied einen L-C-Schwingkreis bilden und das R-Glied zusätzlich parallel zum L-Glied geschaltet ist. Das R-Glied wird durch die erste hochohmige, niederinduktive Verbindung VR1 und die zweite hochohmige, niederinduktive Verbindung VR2 gebildet. Daher ist der Ohm'sche Widerstand der hochohmigen, niederinduktiven Verbindungen VR1, VR2 derart geschaltet, dass er die Schwingung des L-C-Schwingkreises dämpft.

Zusätzlich zu den Gleichspannungen $U_{DC}$ und Gleichspannung $U_{DC}^{*}$ werden parasitäre Wechselspannungsanteile durch die Schaltvorrichtung und den L-C-Schwingkreis in dem System erzeugt. Diese Wechselstromanteile verringern die Effizienz des Umrichters und sollen gedämpft werden. Für eine optimale Dämpfung des L-C-Schwingkreises liegt der Ohm'sche Widerstand der ersten hochohmigen, niederinduktiven Verbindungen VR1 und der zweiten hochohmigen, niederinduktiven Verbindungen VR2 im Bereich von $0{,}1 \cdot R_{opt}$ bis 10 .

$R_{opt}$ und $R_{opt} = \sqrt{L/C}$ $R_{opt}$ mit der Induktivität L der niederohmigen, hochinduktiven Verbindungen VL1, VL2 und der Kapazität C des Zwischenkreiskondensatormodules 30.

Die modulare Zwischenkreisschaltung der Figuren 7 und 8 können um weitere Zwischenkreiskondensatormodule mit entsprechender Schaltung parallel und in einer Kette mit den anderen Zwischenkreiskondensatormodulen 30 erweitert werden. Insbesondere kann eine modulare Zwischenkreisschaltung beispielsweise 1 bis 6 oder 1 bis 8 Zwischenkreiskondensatormodule 30 aufweisen. Alle Zwischenkreiskondensatormodule 30 innerhalb der Kette sind identisch zu ihren benachbarten Zwischenkreiskondensatormodulen 30 untereinander geschaltet. Davon ausgenommen sind die beiden Zwischenkreiskondensatormodule 30 an den Rändern der Kette, da diese nur einen unmittelbaren Nachbarn haben.

In Figur 8 ist der Teil der Schaltung eingezeichnet, der einem Leistungsphasenmodul 10 entspricht. Dabei sind die Schaltvorrichtung 16 und ein Teil der niederohmigen, hochinduktiven Verbindungen VL1, VL2, nämlich die Querbrücken 18, Teil des Leistungsphasenmodules 10. Die hochohmigen, niederinduktiven Verbindungen VR1, VR2 sind nicht Teil des Leistungsphasenmoduls. Das Leistungsphasenmodul 10 wird auch die Stromschienen 30a, 30b aufgesetzt und bildet so die niederohmigen, hochinduktiven Verbindungen VL1, VL2 mit diesen und den im Leistungsphasenmodul 10 angeordneten Querbrücken 18. Die modulare Zwischenkreisschaltung wird in dieser Ausführungsform dadurch erst mit dem Leistungsphasenmodul 10 erzeugt.

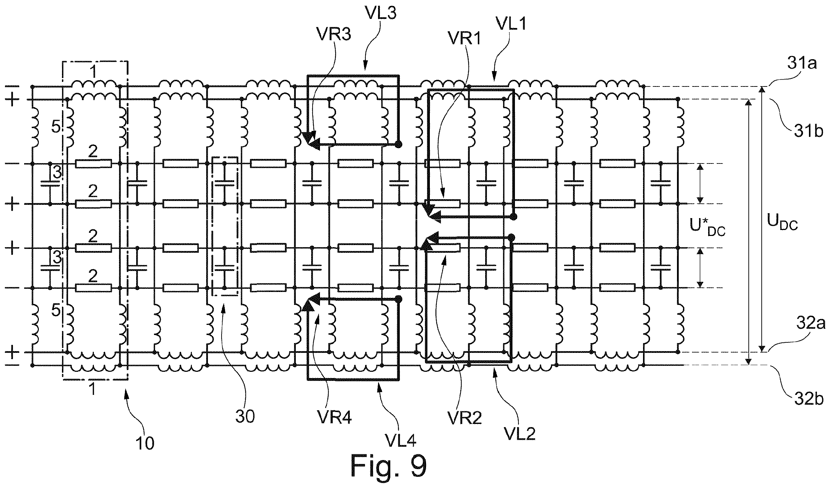

Figur 9 zeigt eine Ausführungsform der modularen Zwischenkreisschaltung. Es sind acht Module dargestellt. Zur Übersicht sind keine Schaltvorrichtungen eingezeichnet. Diese sind jeweils parallel zu den Zwischenkreiskondensatormodulen 30 schaltbar. Alle Zwischenkreiskondensatormodule 30 sind parallel und in einer Kette geschaltet. Sie weisen vier Anschlüsse auf. Zur besseren Übersicht sind weiterhin Bezugszeichen nur einmal eingezeichnet. Jedes Modul der Zwischenkreisschaltung weist identische Bestandteile auf.

Analog zur Figur 8 sind in der Figur 9 Ohm'sche Widerstände der niederohmigen, hochinduktiven Verbindungen VL1, VL2, VL3, VL4 sowie Induktivitäten der hochohmigen, niederinduktiven Verbindungen VR1, VR2, VR3, VR4 nicht eingezeichnet.

In der Ausführungsform der Figur 9 weist jedes Zwischenkreiskondensatormodul 30 jeweils zwei Zwischenkreiskondensatoren auf. Die Zwischenkreiskondensatoren sind zwischen einem ersten Anschluss und einem zweiten Anschluss sowie zwischen einem dritten Anschluss und einem vierten Anschluss des Zwischenkreiskondensatormoduls 30 geschaltet. Der zweite und der dritte Anschluss liegen auf demselben Potential und der erste und der vierte Anschluss liegen auf demselben Potential. Zwischen dem ersten und dem zweiten Anschluss, beziehungsweise zwischen den dritten und dem vierten Anschluss, liegt in einem Betriebszustand eine Gleichspannung $U_{DC}^*$ an. Gegenüber dieser Gleichspannung sind die beiden Zwischenkreiskondensatoren parallel geschaltet.

Die vier Anschlüsse der Zwischenkreiskondensatormodule sind jeweils über eine der niederohmigen, hochinduktiven Verbindungen VL1, VL2, VL3, VL4 und eine der hochohmigen, niederinduktiven Verbindungen VR1, VR2, VR3, VR4 verbunden. Dabei sind die erste hochohmige, niederinduktive Verbindung VR1 parallel zu der zweiten hochohmigen, niederinduktiven Verbindung VR2 geschaltet, die erste niederohmige, hochinduktive Verbindung VL1 parallel zu der zweiten niederohmigen, hochinduktiven Verbindung VL2 geschaltet, die dritten hochohmigen, niederinduktiven Verbindungen VR3 parallel zu den vierten hochohmigen, niederinduktiven Verbindungen VR4 geschaltet, und die dritten niederohmigen, hochinduktiven Verbindungen VL3 parallel zu den vierten niederohmigen, hochinduktiven Verbindungen VL4 geschaltet.

Insbesondere sind die vier niederohmigen, hochinduktiven Verbindungen VL1, VL2, VL3, VL4 voneinander separat und im Wesentlichen, nämlich anhand der Bauteile, die ihre elektrischen Eigenschaften dominieren, voneinander disjunkt. Ebenso können analog jedoch davon unabhängig die hochohmigen, niederinduktiven Verbindungen VR1, VR2, VR3, VR4 VL4 voneinander separat und im Wesentlichen, nämlich anhand der Bauteile, die ihre elektrischen Eigenschaften dominieren, voneinander disjunkt sein.

Eine Gleichspannung $U_{DC}$ liegt jeweils zwischen einer der Stromschienen 31a, 31b des ersten Stromschienenpaares 31 und einer der Stromschienen 32a, 32b des zweiten Stromschienenpaares 32 an. Die Gleichspannung $U_{DC}$ speist in einem Betriebszustand, bei dem die modulare Zwischenkreisschaltung in einer Umrichterschaltung zur Erzeugung einer Wechselspannung genutzt wird, die nicht eingezeichneten Schaltvorrichtungen. An einem AC-Ausgang der Schaltvorrichtung kann eine Wechselspannung abgegriffen werden. In einem anderen Betriebszustand kann die Umrichterschaltung auch umgekehrt eine Gleichspannung aus einer Wechselspannung erzeugen.

Die modulare Zwischenkreisschaltung in der Figur 9 ist derart aufgebaut, dass räumlich neben jedem stromdurchflossenen Leiter ein anderer stromdurchflossener Leiter angeordnet ist, dessen Stromrichtung entgegengesetzt zum ersten Leiter ist. Dadurch wird die Größe von Leiterschleifen minimiert und die Induktivität verringert. Die Umrichterschaltung kann daher auch in einem Umrichter genauso geometrisch umgesetzt werden. Der Teil der Schaltung, der einem Leistungsphasenmodul 10 eines Umrichters entsprechen würde, ist in Figur 9 ebenso skizziert, wobei die Schaltvorrichtung nicht eingezeichnet ist.

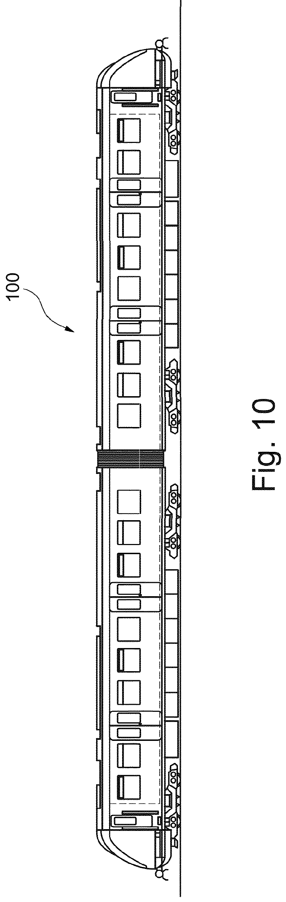

Figur 10 zeigt ein Schienenfahrzeug 100 gemäß einer Ausführungsform mit einem Energiewandler zum Umwandeln von elektrischer Energie in Bewegungsenergie oder umgekehrt und einem Umrichter, wobei mindestens ein AC-Anschluss eines Leistungsphasenmoduls mit dem Energiewandler verbunden ist. Mit dem vom Umrichter erzeugten Wechselstrom kann beispielsweise der Elektromotor zum Antrieb des Fahrzeuges angetrieben werden. Ebenso kann die Boardelektronik mit Strom versorgt werden. Die Frequenz und Spannung an dem oder den AC-Ausgängen kann an die Nutzung im Fahrzeug angepasst werden.

Die vorstehend beschriebenen Ausführungsformen können beliebig miteinander kombiniert werden, beispielsweise können die Zwischenkreiskondensatormodule 30 der Figuren 7 und 8 ebenso mehrere Zwischenkreiskondensatoren aufweisen.

Wenngleich hierin spezifische Ausführungsformen dargestellt und beschrieben worden sind, liegt es im Rahmen der vorliegenden Erfindung, die gezeigten Ausführungsformen geeignet zu modifizieren, ohne vom Schutzbereich der vorliegenden Erfindung abzuweichen. Die nachfolgenden Ansprüche stellen einen ersten, nicht bindenden Versuch dar, die Erfindung allgemein zu definieren.

**Patentansprüche**

1. Leistungsphasenmodul (10) für einen modularen Umrichter, aufweisend:

    - mindestens ein erstes DC-Anschlusspaar (14) mit jeweiligen Verbindungselementen an einer Stirnseite (12) des Leistungsphasenmoduls (10) zum Anschließen an ein Stromschienenpaar,
    - ein zum ersten DC-Anschlusspaar (14) beabstandetes und zu diesem parallel geschaltetes erstes DC-Kondensator-Anschlusspaar (15) mit jeweiligen Verbindungselementen an der Stirnseite (12) zum Anschließen an ein dem Leistungsphasenmodul (10) zugeordnetes Zwischenkreiskondensatormodul (30),
    - einen ersten AC-Anschluss (13),
    - eine Schaltvorrichtung (16) verbunden mit dem ersten AC-Anschluss (13) und dem ersten DC-Anschlusspaar (14) zum Umrichten einer in einem Betriebszustand am ersten DC-Anschlusspaar (14) anliegenden Gleichspannung in eine am ersten AC-Anschluss (13) erzeugte Wechselspannung oder umgekehrt,
    - eine Kühlvorrichtung (17) zum Abführen von Wärme aus dem

    Leistungsphasenmodul (10), insbesondere aus der Schaltvorrichtung (16).
    **dadurch gekennzeichnet,**
    **dass** der erste AC-Anschluss (13) an einer anderen Seite (11) des Leistungsphasenmoduls (10) als die Stirnseite (12) angeordnet ist und dass das erste DC-Anschlusspaar (14) und das erste DC-Kondensator-Anschlusspaar (15) aus von Querbrücken (18, 19) abgewinkelten Metallblechbereichen gebildet und diese Metallblechbereiche im Wesentlichen in einer Ebene angeordnet sind, wobei die jeweiligen Verbindungselemente des ersten DC-Anschlusspaars (14) und des ersten DC-Kondensator-Anschlusspaars (15) an oder in den abgewinkelten Metallblechbereichen ausgebildet sind.

2. Leistungsphasenmodul nach Anspruch 1, weiterhin aufweisend:

    - ein zweites DC-Kondensator-Anschlusspaar (21), das an der Stirnseite des Leistungsphasenmoduls zum ersten DC-Anschlusspaar (14) und zum ersten DC-Kondensator-Anschlusspaar jeweils beabstandet angeordnet und parallel geschaltet ist.

3. Leistungsphasenmodul nach Anspruch 1 oder 2, weiterhin aufweisend:

    - ein zweites DC-Anschlusspaar (20), das an der Stirnseite des Leistungsphasenmoduls zum ersten DC-Anschlusspaar (14) und zum ersten DC-Kondensator-Anschlusspaar jeweils beabstandet angeordnet und parallel geschaltet ist.

4. Leistungsphasenmodul nach Anspruch 3, wobei das erste DC-Kondensator-Anschlusspaar (15) oder das erste und das zweite DC-Kondensator-Anschlusspaar (15, 21) zwischen dem ersten DC-Anschlusspaar (14) und dem zweiten DC-Anschlusspaar (20) in einer Reihe angeordnet sind.

5. Leistungsphasenmodul nach einem Ansprüche 1 bis 4, wobei das erste oder das erste und das zweite DC-Kondensator-Anschlusspaar (21) zum lösbaren Verbinden mit korrespondierenden Kontaktelementen eines an der Stirnseite platzierbaren Zwischenkreiskondensatormoduls ausgebildet sind.

6. Leistungsphasenmodul nach einem der Ansprüche 1 bis 5, wobei die Kontaktelemente des Zwischenkreiskondensatormoduls ausschließlich an einer Fläche des Zwischenkreiskondensatormoduls angeordnet sind, wobei diese Fläche der Stirnseite des Leistungsphasenmoduls direkt gegenübersteht.

7. Leistungsphasenmodul nach einem der Ansprüche 1 bis 6, wobei die Verbindungselemente des ersten und/oder des zweiten DC-Kondensator-Anschlusspaares (15, 21) einen anderen Abstand zueinander aufweisen als die Verbindungselemente des ersten und/oder des zweiten DC-Anschlusspaares (14, 20).

8. Leistungsphasenmodul nach einem der Ansprüche 1 bis 7, wobei das erste DC-Anschlusspaar (14), das erste DC-Kondensator-Anschlusspaar (15) und die Schaltvorrichtung (16) jeweils einen ersten und einen zweiten Anschluss aufweisen, und wobei das Leistungsphasenmodul weiterhin aufweist:

   - eine erste Querbrücke (18), die die ersten Anschlüsse des ersten DC-Anschlusspaares (14), des ersten DC-Kondensator-Anschlusspaares (15) und der Schaltvorrichtung (16) elektrisch verbindet,
   - eine zweite Querbrücke (19), die die zweiten Anschlüsse des ersten DC-Anschlusspaares (14), des ersten DC-Kondensator-Anschlusspaares (15) und der Schaltvorrichtung (16) elektrisch verbindet.

9. Leistungsphasenmodul nach Anspruch 8, wobei die erste Querbrücke (18) und die zweite Querbrücke (19) unmittelbar nebeneinander und abschnittsweise parallel zueinander verlaufen ohne in direktem elektrischem Kontakt zu stehen.

10. Leistungsphasenmodul nach einem der Ansprüche 1 bis 9, wobei das Leistungsphasenmodul eine Gesamtmasse von weniger als 50 kg, insbesondere weniger als 30 kg, besitzt.

11. Umrichter mit mindestens zwei, insbesondere mindestens drei, Leistungsphasenmodulen nach einem der Ansprüche 1 bis 10 und mindestens zwei, insbesondere mindestens drei, Zwischenkreiskondensatormodule (30), wobei jedes Leistungsphasenmodul mit seiner Stirnseite auf einem ihm zugeordneten Zwischenkreiskondensatormodul (30) angeordnet ist, und wobei das erste und/oder das zweite DC-Kondensator-Anschlusspaar (15, 21) jedes Leistungsphasenmodules mit korrespondierenden Kontaktelementen des zugeordneten Zwischenkreiskondensatormodules (30) lösbar verbunden sind.

12. Umrichter nach Anspruch 11, weiterhin aufweisend:

   - ein Stromschienenpaar (31) mit einer ersten Stromschiene (31a) und einer parallel zur ersten Stromschiene verlaufenden zweiten Stromschiene (31b) zum Führen eines Gleichstroms,

   wobei die erste Stromschiene (31a) und die zweite Stromschiene (31b) im Wesentlichen in einer Ebene liegen und die Leistungsphasenmodule mit ihren Stirnseiten nebeneinander und parallel zu dieser Ebene angeordnet sind, und wobei das erste DC-Anschlusspaar (14) jedes Leistungsphasenmodules über seine Verbindungselemente an die erste Stromschiene (31a) und an die zweite Stromschiene (31b) angeschlossen ist.

13. Umrichter nach Anspruch 11 oder 12, weiterhin aufweisend:

   - ein Verbinderpaar (33) mit einem ersten Verbinder (33a) und einem zweiten Verbinder (33b),

   wobei der erste Verbinder (33a) und der zweite Verbinder (32a) im Wesentlichen in einer Ebene liegen und die Leistungsphasenmodule mit ihren Stirnseiten nebeneinander und parallel zu dieser Ebene angeordnet sind, und wobei das erste DC-Kondensator-Anschlusspaar (15) jedes Leistungsphasenmodules über seine Verbindungselemente an den ersten Verbinder (33a) und den zweiten Verbinder (32a) angeschlossen ist.

14. Umrichter nach Anspruch 13, wobei die ersten DC-Anschlusspaare (15) benachbarter Leistungsphasenmodule zusammen mit dem ersten Stromschienenpaar (31) eine hochinduktive, niederohmige Parallelschaltung zwischen benachbarten Zwischenkreiskondensatormodulen (30) bilden, und wobei ein Verbinderpaar (33) eine niederinduktive, hochohmige Parallelschaltung zwischen benachbarten Zwischenkreiskondensatormodulen (30) bildet.

15. Fahrzeug, insbesondere Schienenfahrzeug, mit einem Energiewandler zum Umwandeln von elektrischer Energie in Bewegungsenergie oder umgekehrt und einem Umrichter nach einem der Ansprüche 11 bis 14, wobei mindestens ein AC-Anschluss eines Leistungsphasenmoduls mit dem Energiewandler verbunden ist.

**Claims**

1. A power phase module (10) for a modular converter, the power phase module having:

   - at least one first DC terminal pair (14) with respective connection elements on an end face (12) of the power phase module (10) for connection to a busbar pair,
   - a first DC capacitor terminal pair (15) that is spaced apart from the first DC terminal pair (14) and is connected in parallel therewith, the first DC capacitor terminal pair having respective connection elements on the end face (12) for connection to an intermediate circuit capacitor module (30) associated with the power phase module (10),
   - a first AC terminal (13),
   - a switching device (16) connected to the first AC terminal (13) and the first DC terminal pair (14) for inverting a direct voltage, which is present across the first DC terminal pair (14) in an operating state, into an alternating voltage produced at the first AC terminal (13), or vice versa,

- a cooling device (17) to dissipate heat from the power phase module (10), in particular from the switching device (16),

**characterised in that**
the first AC terminal (13) is arranged on a side (11) of the power phase module (10) other than the end face (12), and **in that** the first DC terminal pair (14) and the first DC capacitor terminal pair (15) are formed from sheet metal areas bent away from cross bridges (18, 19) and said sheet metal areas are arranged substantially in one plane, the respective connection elements of the first DC terminal pair (14) and of the first DC capacitor terminal pair (15) being formed on or in the bent sheet metal areas.

2. The power phase module according to claim 1, further having:

    - a second DC capacitor terminal pair (21) that is arranged on the end face of the power phase module, spaced apart from each of the first DC terminal pair (14) and the first DC capacitor terminal pair, and connected in parallel.

3. The power phase module according to claim 1 or 2, further having:

    - a second DC terminal pair (20) that is arranged on the end face of the power phase module, spaced apart from each of the first DC terminal pair (14) and the first DC capacitor terminal pair, and connected in parallel.

4. The power phase module according to claim 3, wherein the first DC capacitor terminal pair (15) or the first and the second DC capacitor terminal pair (15, 21) are arranged in a row between the first DC terminal pair (14) and the second DC terminal pair (20).

5. The power phase module according to one of claims 1 to 4, wherein the first or the first and the second DC capacitor terminal pair (21) are designed for detachable connection to corresponding contact elements of an intermediate circuit capacitor module that is mountable on the end face.

6. The power phase module according to one of claims 1 to 5, wherein the contact elements of the intermediate circuit capacitor module are arranged exclusively on a surface of the intermediate circuit capacitor module, wherein said surface is directly opposite the end face of the power phase module.

7. The power phase module according to one of claims 1 to 6, wherein the connection elements of the first and/or the second DC capacitor terminal pair (15, 21) have a distance to one another that is different from the distance of the connection elements of the first and/or the second DC terminal pair (14, 20).

8. The power phase module according to one of claims 1 to 7, wherein the first DC terminal pair (14), the first DC capacitor terminal pair (15), and the switching device (16) each have a first and a second terminal, and wherein the power phase module further has:

    - a first cross bridge (18) that electrically connects the first terminals of the first DC terminal pair (14), of the first DC capacitor terminal pair (15), and of the switching device (16),
    - a second cross bridge (19) that electrically connects the second terminals of the first DC terminal pair (14), of the first DC capacitor terminal pair (15), and of the switching device (16).

9. The power phase module according to claim 8, wherein the first cross bridge (18) and the second cross bridge (19) extend directly next to one another and portions of them extend parallel to one another, without being in direct electrical contact.

10. The power phase module according to one of claims 1 to 9, wherein the power phase module has a total mass of less than 50 kg, in particular less than 30 kg.

11. A converter with at least two, in particular at least three power phase modules according to one of claims 1 to 10 and at least two, in particular at least three intermediate circuit capacitor modules (30), wherein every power phase module is arranged with its end face on an intermediate circuit capacitor module (30) that is associated with the particular power phase module, and wherein the first and/or the second DC capacitor terminal pair (15, 21) of every power phase module is detachably connected to corresponding contact elements of the associated intermediate circuit capacitor module (30).

12. The converter according to claim 11, further having:

    - a busbar pair (31) with a first busbar (31a) and a second busbar (31b) extending parallel to the first busbar to conduct a direct current,

    wherein the first busbar (31a) and the second busbar (31b) lie substantially in one plane and the end faces of the power phase modules are arranged next to one another and parallel to this plane, and wherein the first DC terminal pair (14) of each power phase module is connected to the first busbar (31a) and to the second busbar (31b) via its connection elements.

13. The converter according to claim 11 or 12, further having:

   - a connector pair (33) with a first connector (33a) and a second connector (33b),

   wherein the first connector (33a) and the second connector (32a) lie substantially in one plane and the end faces of the power phase modules are arranged next to one another and parallel to this plane, and wherein the first DC capacitor terminal pair (15) of each power phase module is connected to the first connector (33a) and to the second connector (32a) via its connection elements.

14. The converter according to claim 13, wherein the first DC terminal pairs (15) of adjacent power phase modules together with the first busbar pair (31) form a high-inductance, low-resistance parallel connection between adjacent intermediate circuit capacitor modules (30), and wherein a connector pair (33) forms a low-inductance, high-resistance parallel connection between adjacent intermediate circuit capacitor modules (30).

15. A vehicle, in particular rail vehicle, with an energy converter for converting electrical energy into kinetic energy, or vice versa, and with a converter according to one of claims 11 to 14, wherein at least one AC terminal of a power phase module is connected to the energy converter.

**Revendications**

1. Module de phase de puissance (10) pour un variateur modulaire, présentant :

   - au moins une première paire de bornes à courant continu (14) avec des éléments de connexion respectifs sur une face frontale (12) du module de phase de puissance (10) destinés à être connectés à une paire de rails conducteurs,
   - une première paire de bornes de condensateur à courant continu (15) espacée de la première paire de bornes à courant continu (14) et montée en parallèle par rapport à celle-ci, avec des éléments de connexion respectifs sur la face frontale (12) destinés à être connectés à un module de condensateur de circuit intermédiaire (30) associé au module de phase de puissance (10),
   - une première borne à courant alternatif (13),
   - un dispositif de commutation (16) connecté à la première borne à courant alternatif (13) et à la première paire de bornes à courant continu (14), destiné à convertir une tension continue s'appliquant à la première paire de bornes à courant continu (14) dans un état de fonctionnement en une tension alternative générée sur la première borne à courant alternatif (13) ou inversement,
   - un dispositif de refroidissement (17) destiné à évacuer la chaleur émanant du module de phase de puissance (10), en particulier du dispositif de commutation (16),

   **caractérisé en ce que** la première borne à courant alternatif (13) est disposée sur une autre face (11) du module de phase de puissance (10) que la face frontale (12) et que la première paire de bornes à courant continu (14) et la première paire de bornes de condensateur à courant continu (15) sont formées de zones de tôles métalliques coudées par des ponts transversaux (18, 19) et ces zones de tôles métalliques sont disposées sensiblement dans un plan, dans lequel les éléments de connexion respectifs de la première paire de bornes à courant continu (14) et de la première paire de bornes de condensateur à courant continu (15) sont réalisés sur ou dans les zones de tôles métalliques coudées.

2. Module de phase de puissance selon la revendication 1, présentant en outre :

   - une deuxième paire de bornes de condensateur à courant continu (21), qui, sur la face frontale du module de phase de puissance, est disposée respectivement de manière espacée et montée en parallèle par rapport à la première paire de bornes à courant continu (14) et à la première paire de bornes de condensateur à courant continu.

3. Module de phase de puissance selon la revendication 1 ou 2, présentant en outre :

   - une deuxième paire de bornes à courant continu (20), qui, sur la face frontale du module de phase de puissance respectivement, est disposée de manière espacée et montée en parallèle par rapport à la première paire de bornes à courant continu (14) et à la première paire de bornes de condensateur à courant continu.

4. Module de phase de puissance selon la revendication 3, dans lequel la première paire de bornes de condensateur à courant continu (15) ou la première et la deuxième paire de bornes de condensateur à courant continu (15, 21) sont disposées en ligne entre la première paire de bornes à courant continu (14) et la deuxième paire de bornes à courant continu (20).

**5.** Module de phase de puissance selon l'une quelconque des revendications 1 à 4, dans lequel la première ou la première et la deuxième paire de bornes de condensateur à courant continu (21) sont configurées pour être connectées de manière détachable à des éléments de contact correspondants d'un module de condensateur de circuit intermédiaire pouvant être placé sur la face frontale.

**6.** Module de phase de puissance selon l'une quelconque des revendications 1 à 5, dans lequel les éléments de contact du module de condensateur de circuit intermédiaire sont disposés exclusivement sur une surface du module de condensateur de circuit intermédiaire, dans lequel cette surface est directement opposée à la face frontale du module de phase de puissance.

**7.** Module de phase de puissance selon l'une quelconque des revendications 1 à 6, dans lequel les éléments de connexion de la première et/ou de la deuxième paire de bornes de condensateur à courant continu (15, 21) présentent une autre distance les uns par rapport aux autres que les éléments de connexion de la première et/ou de la deuxième paire de bornes à courant continu (14, 20).

**8.** Module de phase de puissance selon l'une quelconque des revendications 1 à 7, dans lequel la première paire de bornes à courant continu (14), la première paire de bornes de condensateur à courant continu (15) et le dispositif de commutation (16) présentent respectivement une première et une deuxième borne, et dans lequel le module de phase de puissance présente en outre :

- un premier pont transversal (18), qui connecte électriquement les premières bornes de la première paire de bornes à courant continu (14), de la première paire de bornes de condensateur à courant continu (15) et du dispositif de commutation (16),
- un deuxième pont transversal (19), qui connecte électriquement les deuxièmes bornes de la première paire de bornes à courant continu (14), de la première paire de bornes de condensateur à courant continu (15) et du dispositif de commutation (16).

**9.** Module de phase de puissance selon la revendication 8, dans lequel le premier pont transversal (18) et le deuxième pont transversal (19) s'étendent directement l'un à côté de l'autre et parallèlement l'un à l'autre sur certaines parties sans être en contact électrique direct.

**10.** Module de phase de puissance selon l'une quelconque des revendications 1 à 9, dans lequel le module de phase de puissance possède une masse totale inférieure à 50 kg, en particulier inférieure à 30 kg.

**11.** Variateur avec au moins deux, en particulier au moins trois, modules de phase de puissance selon l'une quelconque des revendications 1 à 10 et au moins deux, en particulier au moins trois modules de condensateur de circuit intermédiaire (30), dans lequel chaque module de phase de puissance est disposé avec sa face frontale sur un module de condensateur de circuit intermédiaire (30) associé à celui-ci, et dans lequel la première et/ou la deuxième paire de bornes de condensateur à courant continu (15, 21) de chaque module de phase de puissance sont connectées de manière détachable à des éléments de contact correspondants du module de condensateur de circuit intermédiaire (30) associé.

**12.** Variateur selon la revendication 11, présentant en outre :

- une paire de rails conducteurs (31) avec un premier rail conducteur (31a) et un deuxième rail conducteur (31b) s'étendant parallèlement au premier rail conducteur, destiné à transporter un courant continu,

dans lequel le premier rail conducteur (31a) et le deuxième rail conducteur (31b) se situent sensiblement dans un plan et les modules de phase de puissance avec leurs faces frontales sont disposés les uns à côté des autres et parallèlement à ce plan, et dans lequel la première paire de bornes à courant continu (14) de chaque module de phase de puissance est raccordée au premier rail conducteur (31a) et au deuxième rail conducteur (31b) par l'intermédiaire de ses éléments de connexion.

**13.** Variateur selon la revendication 11 ou 12, présentant en outre :

- une paire de connecteurs (33) avec un premier connecteur (33a) et un deuxième connecteur (33b),

dans lequel le premier connecteur (33a) et le deuxième connecteur (32a) se situent sensiblement dans un plan et les modules de phase de puissance avec leurs faces frontales sont disposés les uns à côté des autres et parallèlement à ce plan, et dans lequel la première paire de bornes de condensateur à courant continu (15) de chaque module de phase de puissance est raccordée au premier connecteur (33a) et au deuxième connecteur (32a) par l'intermédiaire de ses éléments de connexion.

**14.** Variateur selon la revendication 13, dans lequel les premières paires de bornes à courant continu (15) de modules de phase de puissance voisins forment conjointement avec la première paire de rails conducteurs (31) un montage en parallèle hautement inductif, de faible impédance entre des modules de condensateur de circuit intermédiaire (30) voisins, et dans lequel une paire de connecteurs (33) forme un montage en parallèle faiblement inductif, de haute impédance entre des modules de condensateur de circuit intermédiaire (30) voisins.

15. Véhicule, en particulier véhicule ferroviaire, avec un variateur d'énergie destiné à convertir de l'énergie électrique en énergie cinétique ou inversement et un variateur selon l'une quelconque des revendications 11 à 14, dans lequel au moins une borne à courant alternatif d'un module de phase de puissance est connectée au variateur d'énergie.

Fig. 1

EP 3 632 197 B1

Fig. 2

EP 3 632 197 B1

Fig. 3

Fig. 4

Fig. 5

Fig. 6

Fig. 7

Fig. 8

Fig. 9

EP 3 632 197 B1

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69209093 T2